# EUROPEAN PATENT APPLICATION

(11) **EP 4 845 348 A1**
(43) Date of publication of application: **25.11.2026**
(21) Application number: 25215426.5
(22) Date of filing: 13.11.2025
(51) Int. Cl.: H10F 19/90, H10F 77/14, H10F 77/00

(54) **PHOTOVOLTAIC MODULE AND METHOD FOR MANUFACTURING THE SAME**

(30) Priority: 22.05.2025 CN 202510668957
(71) Applicant: JINKO SOLAR CO., LTD, ShangRao, Jiangxi 334100 (CN); Jinko Solar (Haining) Co., Ltd., Haining City, Zhejiang 314415 (CN)
(72) Inventor: WANG, Luchuang, Shangrao Economic Development Zone, 334100 (CN); ZHAO, Zijie, Shangrao Economic Development Zone, 334100 (CN); YANG, Jingguo, Shangrao Economic Development Zone, 334100 (CN); PENG, Yingying, Shangrao Economic Development Zone, 334100 (CN); TAO, Wusong, Shangrao Economic Development Zone, 334100 (CN)
(74) Representative: Rösler Rasch van der Heide & Partner

(57) **Abstract**

The present disclosure relates to the field of photovoltaic, and provides a photovoltaic module and a method for manufacturing the same. The photovoltaic module includes a plurality of solar cell strings, and the solar cell string includes a plurality of solar cells. The chamfer edge of the first end solar cell is arranged opposite to the chamfer edge of the third end solar cell, and the chamfer edge of the second end solar cell is arranged opposite to the chamfer edge of the fourth end solar cell. An edge busbar, adjacent to the second end solar cell, of the first end solar cell and an edge busbar, adjacent to the fourth end solar cell, of the third end solar cell are both the second busbar. An edge busbar, adjacent to the first end solar cell, of the second end solar cell and an edge busbar, adjacent to the third end solar cell, of the fourth end solar cell are both the first busbar. The first busbars of the first end solar cell and the third end solar cell are both connected to the same center current collector, and the second busbars of the second end solar cell and the fourth end solar cell are both connected to another adjacent center current collector. The risk of short circuit of the photovoltaic module is thereby reduced.

## Description

### TECHNICAL FIELD

The present disclosure relates to the field of photovoltaic technology, and in particular, to a photovoltaic module and a method for manufacturing the photovoltaic module.

### BACKGROUND

Solar energy is an inexhaustible renewable energy source for human beings. A photovoltaic module is not only the core part but also the most important part of a solar power generation system, serves to convert solar energy into electrical energy, and to send the electrical energy to a storage battery for storage or to drive a load to operate.

The photovoltaic module includes a plurality of solar cell strings. Each solar cell string includes a plurality of solar cells connected in series with each other. The plurality of solar cell strings are respectively connected to a center current collector. Lead wires connected to an end of the center current collector conduct current collected by grid lines of the solar cells to outside of the photovoltaic module. In existing photovoltaic modules, the arrangement of the solar cells is limited by space size, resulting in a risk of contact short circuit between the lead wires.

### SUMMARY

In view of the above, an adhesive printing screen and a photovoltaic module are provided herein for facilitating solution of the problem of short circuit caused by too small spacing between lead wires in the existing technology.

In a first aspect, one or more embodiments of the present disclosure provides a photovoltaic module, including: a first solar cell string group including a first solar cell string and a second solar cell string arranged alternately in a first direction; a second solar cell string group including a third solar cell string and a fourth solar cell string arranged alternately in the first direction; and a center current collector located between the first solar cell string group and the second solar cell string group, where a plurality of center current collectors are spaced apart in the first direction. The first solar cell string, the second solar cell string, the third solar cell string, and the fourth solar cell string respectively include a plurality of solar cells spaced apart in a second direction, and the solar cell is a back contact solar cell or a back contact tandem solar cell. The solar cell includes a first busbar and a second busbar spaced apart in the first direction. Ends, closed to the center current collector, of the first solar cell string, the second solar cell string, the third solar cell string, and the fourth solar cell string respectively have a first end solar cell, a second end solar cell, a third end solar cell, and a fourth end solar cell. An edge busbar, adjacent to the second end solar cell, of the first end solar cell and an edge busbar, adjacent to the fourth end solar cell, of the third end solar cell are both the second busbar. An edge busbar, adjacent to the first end solar cell, of the second end solar cell and an edge busbar, adjacent to the third end solar cell, of the fourth end solar cell are both the first busbar. The first busbar of the first end solar cell and the first busbar of the third end solar cell are respectively connected to the same center current collector through a solder strip, and the second busbar of the second end solar cell and the second busbar of the fourth end solar cell are respectively connected to another adjacent center current collector through a solder strip. A chamfer edge of the first end solar cell is arranged opposite to a chamfer edge of the third end solar cell, and a chamfer edge of the second end solar cell is arranged opposite to a chamfer edge of the fourth end solar cell. The first direction is perpendicular to the second direction.

In one or more embodiments, chamfer edges of any two adjacent solar cells in the first direction are arranged parallel.

In one or more embodiments, chamfer edges of a plurality of the solar cells in the same solar cell string are arranged parallel.

In one or more embodiments, a chamfer size of the solar cell is A×45°, where A satisfies 1 mm ≤ A ≤ 2 mm.

In one or more embodiments, in the first direction, a spacing L1 between two adjacent center current collectors ranges from 15 mm to 25 mm.

In one or more embodiments, the solder strip includes a first solder strip and a second solder strip, where the first solder strip serves to connect the center current collector with the first busbar of the first end solar cell, the second solder strip serves to connect the center current collector with the first busbar of the third end solar cell, and the first solder strip and the second solder strip are staggered in the second direction; and/or, the solder strip includes a third solder strip and a fourth solder strip, where the third solder strip serves to connect the center current collector with the second busbar of the second end solar cell, the fourth solder strip serves to connect the center current collector with the second busbar of the fourth end solar cell, and the third solder strip and the fourth solder strip are staggered in the second direction.

In one or more embodiments, the photovoltaic module further includes a first edge current collector and a second edge current collector arranged opposite in the second direction. Ends, closed to the first edge current collector, of the first solar cell string and the second solar cell string respectively have a fifth end solar cell and a sixth end solar cell. A second busbar of the fifth end solar cell and a first busbar of the sixth end solar cell are respectively connected to the first edge current collector through the solder strip. Ends, closed to the second edge current collector, of the third solar cell string and the fourth solar cell string respectively have a seventh end solar cell and an eighth end solar cell. A second busbar of the seventh end solar cell and a first busbar of the eighth end solar cell are respectively connected to the second edge current collector through the solder strip.

In one or more embodiments, a number of the solar cells in each of the first solar cell string, the second solar cell string, the third solar cell string, and the fourth solar cell string is even. An edge busbar, adjacent to the sixth end solar cell, of the fifth end solar cell and an edge busbar, adjacent to the eighth end solar cell, of the seventh end solar cell are both the first busbar. An edge busbar, adjacent to the fifth end solar cell, of the sixth end solar cell and an edge busbar, adjacent to the seventh end solar cell, of the eighth end solar cell are both the second busbar.

In one or more embodiments, a number of the solar cells in each of the first solar cell string, the second solar cell string, the third solar cell string, and the fourth solar cell string is odd. An edge busbar, adjacent to the sixth end solar cell, of the fifth end solar cell and an edge busbar, adjacent to the eighth end solar cell, of the seventh end solar cell are both the second busbar. An edge busbar, adjacent to the fifth end solar cell, of the sixth end solar cell and an edge busbar, adjacent to the seventh end solar cell, of the eighth end solar cell are both the first busbar.

In one or more embodiments, a sum of numbers of the first busbar and the second busbar of the solar cell is even.

In one or more embodiments, the solar cell is a cut cell. The solar cell includes a first solar cell and a second solar cell, where one of the first solar cell and the second solar cell has a structure that is symmetrical to a 180° rotated structure of the other one.

In a second aspect, one or more embodiments of the present disclosure provides a method for manufacturing the photovoltaic module, including: providing a solar cell, where the solar cell is a back contact solar cell or a back contact tandem solar cell, the solar cell includes a first busbar and a second busbar spaced apart in a first direction, and the solar cell further has a chamfer edge; arranging a plurality of the solar cells in a second direction to respectively form a first solar cell string, a second solar cell string, a third solar cell string, and a fourth solar cell string, where the first solar cell string, the second solar cell string, the third solar cell string, and the fourth solar cell string respectively have a first end solar cell, a second end solar cell, a third end solar cell, and a fourth end solar cell, an edge busbar, adjacent to the second end solar cell, of the first end solar cell and an edge busbar, adjacent to the fourth end solar cell, of the third end solar cell are both the second busbar, an edge busbar, adjacent to the first end solar cell, of the second end solar cell and an edge busbar, adjacent to the third end solar cell, of the fourth end solar cell are both the first busbar, a chamfer edge of the first end solar cell is arranged opposite to a chamfer edge of the third end solar cell, and a chamfer edge of the second end solar cell is arranged opposite to a chamfer edge of the fourth end solar cell; and connecting the first busbar of the first end solar cell and the first busbar of the third end solar cell to the same center current collector, and connecting the second busbar of the second end solar cell and the second busbar of the third end solar cell to another adjacent center current collector. The second direction is perpendicular to the first direction.

In one or more embodiments, chamfer edges of a plurality of the solar cells in the same solar cell string are arranged parallel. A sum of numbers of the first busbar and the second busbar of the solar cell is even. The solar cell is a cut cell. The solar cell includes a first solar cell and a second solar cell that are rotationally symmetrical. For providing a solar cell, the method for manufacturing the photovoltaic module includes: providing an original solar cell; cutting in a center line in the second direction of the original solar cell to obtain two cut cells; and rotating one of the cut cells by 180° to obtain the first solar cell and the second solar cell with chamfer edges arranged parallel.

In one or more embodiments, a number of the solar cells in each of the first solar cell string, the second solar cell string, the third solar cell string, and the fourth solar cell string is odd. For forming the second solar cell string, the method for manufacturing the photovoltaic module includes: alternately arranging a plurality of the first solar cells and a plurality of the second solar cells in the second direction, and connecting the first solar cell and the second solar cell that are adjacent through the solder strip to obtain a pre-fabricated second solar cell string; and rotating the pre-fabricated second solar cell string as a whole by 180° to obtain the second solar cell string; and/or for forming the third solar cell string, the method for manufacturing the photovoltaic module includes: alternately arranging a plurality of the second solar cells and a plurality of the first solar cells in the second direction, and connecting the first solar cell and the second solar cell that are adjacent through the solder strip to obtain the third solar cell string.

In one or more embodiments, for forming the first solar cell string, the method for manufacturing the photovoltaic module includes: alternately arranging a plurality of the first solar cells and a plurality of the second solar cells in the second direction; connecting the first solar cell and the second solar cell that are adjacent through the solder strip to obtain a pre-fabricated first solar cell string, where the solder strip in the pre-fabricated first solar cell string and the solder strip in the pre-fabricated second solar cell string are arranged in a mirror-symmetric distribution; and rotating the pre-fabricated first solar cell string as a whole by 180° to obtain the first solar cell string; and/or for forming the fourth solar cell string, the method for manufacturing the photovoltaic module includes: alternately arranging a plurality of the second solar cells and a plurality of the first solar cells in the second direction; and connecting the first solar cell and the second solar cell that are adjacent through the solder strip to obtain the fourth solar cell string, where the solder strip in the fourth solar cell string and the solder strip in the third solar cell string are arranged in a mirror-symmetric distribution.

According to the present disclosure, the edge busbar, closed to the lead wire, of any end solar cell is not electrically connected to the center current collector, so that there is sufficient space between two adjacent center current collectors for providing the lead wire, ensuring there is a large spacing between the lead wires of the two adjacent center current collectors, thereby preventing the problem of short circuit caused by contact between two adjacent lead wires. When the chamfer edges of a plurality of the solar cells in the same solar cell string have a consistent direction, the solder strip has a consistent contact area with the edges of each solar cell in the same solar cell string, which facilitates reducing the risk of false soldering. In addition, the edges of the each solar cell are subjected to a more uniform pressure, which facilitates reducing the fragmentation rate during the string soldering or the laminating, thereby improving the yield of the photovoltaic module. Furthermore, when the chamfer edges of a plurality of the solar cells in the same solar cell string have a consistent direction, if the photovoltaic module is installed at an inclination, the risk of mutual shielding by the edge shadows of adjacent solar cells is reduced, which facilitates improvement of the output power of the photovoltaic module. In addition, when the chamfer edge of the first end solar cell is arranged opposite to the chamfer edge of the third end solar cell, and the chamfer edge of the second end solar cell is arranged opposite to the chamfer edge of the fourth end solar cell, the chamfer edges of the first end solar cell, the second end solar cell, the third end solar cell, and the fourth end solar cell are all arranged toward the lead wire, thereby providing more arrangement space for the lead wires, and further reducing the risk of contact between two adjacent lead wires. In addition, by such arrangement, the aesthetic appearance of the layout of the photovoltaic module can be improved.

It should be understood that the general description above and the detailed description in the following are merely illustrative, and should not limit the present disclosure.

### BRIEF DESCRIPTION OF DRAWINGS

In order to better illustrate the technical solutions in embodiments of the present disclosure, the drawings used in the description of embodiments are briefly described as below.
FIG. 1 is a circuit diagram of a photovoltaic module according to one or more embodiments of the present disclosure;
FIG. 2 is a schematic structural diagram of the layout of a photovoltaic module according to one or more embodiments of the present disclosure;
FIG. 3 is a schematic structural diagram of a solar cell string shown in FIG. 1;
FIG. 4 is a schematic structural diagram of a solar cell shown in FIG. 3;
FIG. 5 is a schematic structural diagram of the portion I shown in FIG. 2 according to a first embodiment;
FIG. 6 is a schematic structural diagram of the layout of a photovoltaic module according to one or more embodiments of the present disclosure;
FIG. 7 is a schematic structural diagram of the portion II shown in FIG. 6 according to a first embodiment;
FIG. 8 is a schematic cross-sectional structural diagram of a photovoltaic module according to one or more embodiments of the present disclosure;
FIG. 9 is a schematic structural diagram of the portion I shown in FIG. 2 according to a second embodiment;
FIG. 10 is a schematic structural diagram of an uncut cell according to one or more embodiments of the present disclosure;
FIG. 11 is a schematic structural diagram of the solar cell shown in FIG. 10 after being cut;
FIG. 12 is a schematic structural diagram of the portion I shown in FIG. 1 according to a third embodiment;
FIG. 13 is a schematic structural diagram of the portion II shown in FIG. 6 according to a second embodiment;
FIG. 14 is a schematic structural diagram of a solar cell string shown in FIG. 1 according to other one or more embodiments;
FIG. 15 is a schematic structural diagram of an uncut cell according to other one or more embodiments of the present disclosure;
FIG. 16 is a schematic structural diagram of the solar cell shown in FIG. 15 after being cut;
FIG. 17 is a schematic structural diagram of the portion I shown in FIG. 2 according to a fourth embodiment;
FIG. 18 is a schematic structural diagram of the portion I shown in FIG. 2 according to a fifth embodiment;
FIG. 19 is a schematic structural diagram of the portion II shown in FIG. 6 according to a third embodiment;
FIG. 20 is a schematic structural diagram of the portion II shown in FIG. 6 according to a fourth embodiment;
FIG. 21 is a flowchart of a method for manufacturing a photovoltaic module according to one or more embodiments of the present disclosure;
FIG. 22 is a flowchart of a method for manufacturing a photovoltaic module according to one or more embodiments of the present disclosure; and
FIG. 23 is a flowchart of a method for manufacturing a photovoltaic module according to one or more embodiments of the present disclosure.

### Reference signs:

100 - solar cell module;
101 - first solar cell string group;
102 - second solar cell string group;
200 - front sheet;
300 - front encapsulation layer;
400 - back encapsulation layer;
500 - back sheet;
10 - first solar cell string;
10' - pre-fabricated first solar cell string;
20 - second solar cell string;
20' - pre-fabricated second solar cell string;
30 - third solar cell string;
40 - fourth solar cell string;
1 - center current collector;
2-cell;
   201 - first end solar cell;
   202 - second end solar cell;
   203 - third end solar cell;
   204 - fourth end solar cell;
   205 - fifth end solar cell;
   206 - sixth end solar cell;
   207 - seventh end solar cell;
   208 - eighth end solar cell;
   21 - first busbar;
   22 - second busbar;
   23 - first solar cell;
   24 - second solar cell;
   25 - third solar cell;
   26 - fourth solar cell;
   27 - fifth solar cell;
   28 - sixth solar cell;
   29 - seventh solar cell;
   210 - eighth solar cell;
   211 - ninth solar cell;
   212 - tenth solar cell;
3 - solder strip;
   31 - first solder strip;
   32 - second solder strip;
   33 - third solder strip;
   34 - fourth solder strip;
4-first edge current collector; and
5-second edge current collector.

### DESCRIPTION OF EMBODIMENTS

In order to better understand the technical solutions of the present disclosure, embodiments of the present disclosure are described in detail below in conjunction with the drawings.

The terms used in embodiments of the present disclosure are only for the purpose of describing specific embodiments, and are not intended to limit the present disclosure. As used in embodiments of the present disclosure and the appended claims, the singular forms "a/an", "said", and "the" are intended to include the plural forms as well, unless the context clearly indicated otherwise.

It should be understood that the term "and/or" used herein is merely an association relationship describing an associated object, and indicates that there may be three relationships. For example, A and/or B, and may indicate: only A, both A and B, and only B. In addition, the character "/" herein generally indicates that the related objects before and after the character present an "or" relationship.

It should be noted that location terms such as "on/above", "below/under", "left", and "right" described in embodiments of the present disclosure are described with reference to the angles shown in the drawings, and should not be construed as limitations on embodiments of the present disclosure. In addition, in the context, it should be understood that when one element is referred to as being formed "on/above" or "below/under" another element, it is possible that the one element may be directly formed "on/above" or "below/under" another element, or formed "on/above" or "below/under" another element via an intermediate element.

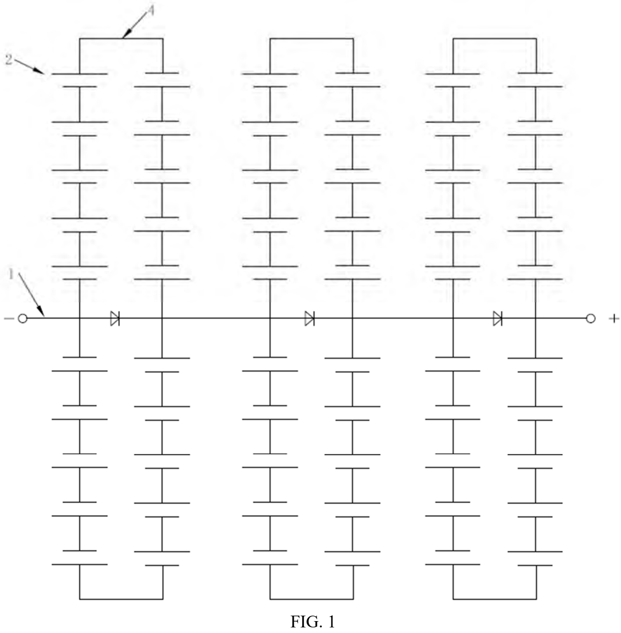

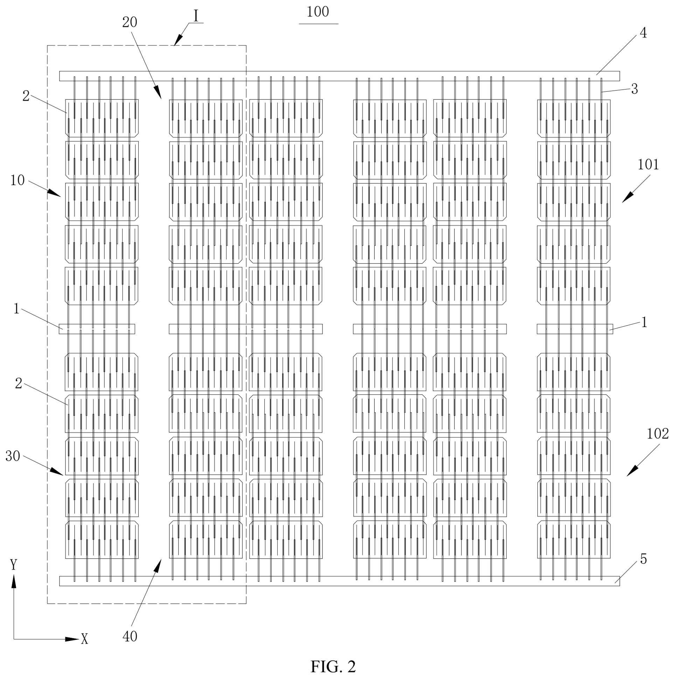

To solve the problem of short circuit caused by too small spacing between lead wires in an existing photovoltaic module, one or more embodiments of the present disclosure provides a photovoltaic module. As shown in FIG. 1 and FIG. 2, the photovoltaic module includes a solar cell module 100, and the solar cell module 100 includes a first solar cell string group 101, a second solar cell string group 102, and a plurality of center current collectors 1. The first solar cell string group 101 includes a first solar cell string 10 and a second solar cell string 20 arranged alternately in a first direction X. The second solar cell string group 102 includes a third solar cell string 30 and a fourth solar cell string 40 arranged alternately in the first direction X. In a second direction Y, a plurality of center current collectors 1 are located between the first solar cell string group 101 and the second solar cell string group 102, where a plurality of center current collectors 1 are spaced apart in the first direction X. In embodiments of the present disclosure, the numbers of the first solar cell string 10, the second solar cell string 20, the third solar cell string 30, and the fourth solar cell string 40 are not limited, which are specifically designed depending on the layout and output power requirements of a photovoltaic module.

It should be noted that the first direction X is perpendicular to the second direction Y. In one or more embodiments of the present disclosure, one of the first direction X and the second direction Y is the length direction of the photovoltaic module, and the other one is the width direction of the photovoltaic module.

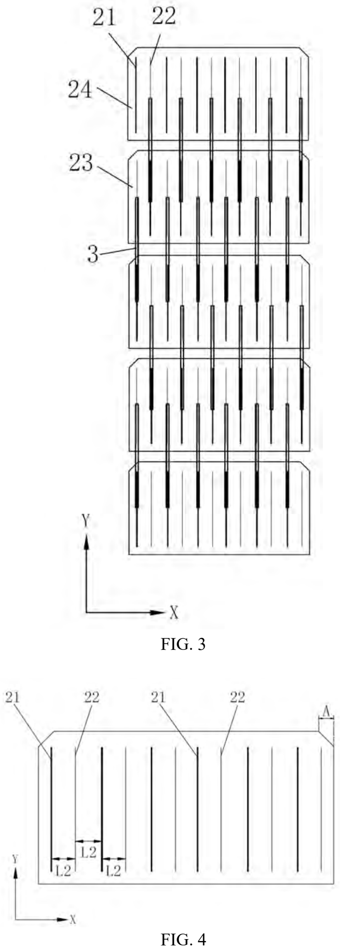

Referring to FIG. 2 and FIG. 3, the first solar cell string 10, the second solar cell string 20, the third solar cell string 30, and the fourth solar cell string 40 respectively include a plurality of solar cells 2 spaced apart in the second direction Y. The plurality of solar cells 2 in the same solar cell string are connected in series through a solder strip 3. The solar cell 2 is a back contact solar cells or a back contact tandem solar cell, which reduces light shading on the front side to improve solar cell efficiency. As shown in FIG. 4, the backlight surface of the solar cell 2 is provided with a first busbar 21 and a second busbar 22 spaced apart in the first direction X. The first busbar 21 and the second busbar 22 have the opposite polarities, that is, one of the first busbar 21 and the second busbar 22 is a positive busbar, and the other one is a negative busbar. One or more embodiments of the present disclosure all take the case where the first busbar 21 is the negative electrode and the second busbar 22 is the positive electrode as examples for illustration.

It should be noted that, lines of different thicknesses are employed in the drawings provided in the present disclosure to distinguish the first busbar 21 from the second busbar 22, which does not constitute a limitation on the relative width between the first busbar 21 and the second busbar 22. The width of the first busbar 21 may be equal to or unequal to the width of the second busbar 22.

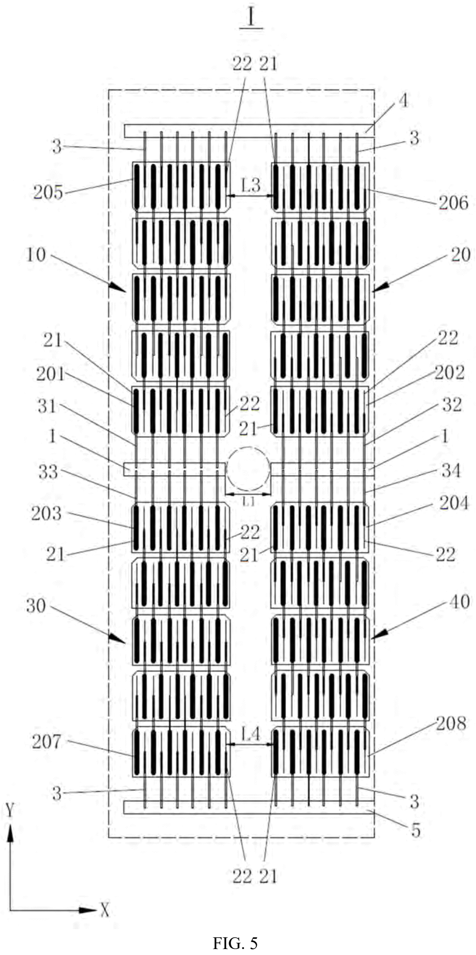

As shown in FIG. 5, ends, closed to the center current collector 1, of the first solar cell string 10, the second solar cell string 20, the third solar cell string 30, and the fourth solar cell string 40 respectively have a first end solar cell 201, a second end solar cell 202, a third end solar cell 203, and a fourth end solar cell 204. The first busbar 21 of the first end solar cell 201 and the first busbar 21 of the third end solar cell 203 are respectively connected to the same center current collector 1 through the solder strip 3, so that the first solar cell string 10 and the third solar cell string 30 are connected in parallel. The second busbar 22 of the second end solar cell 202 and the second busbar 22 of the fourth end solar cell 204 are respectively connected to another adjacent center current collector 1 through the solder strip 3, so that the second solar cell string 20 and the fourth solar cell string 40 are connected in parallel. The edge busbar, adjacent to the second end solar cell 202, of the first end solar cell 201 is the second busbar 22, and the edge busbar, adjacent to the fourth end solar cell 204, of the third end solar cell 203 is the second busbar 22. In addition, the edge busbar, adjacent to the first end solar cell 201, of the second end solar cell 202 is the first busbar 21, and the edge busbar, adjacent to the third end solar cell 203, of the fourth end solar cell 204 is the first busbar 21. By such layout, the edge busbar, closed to the lead wire (the lead wire is not shown in the drawings, but the region indicated by the circular dashed line in the drawings is a region where the lead wire can be arranged), of any end solar cell is not electrically connected to the center current collector 1, so that there is sufficient space between two adjacent center current collectors 1 for providing the lead wire, ensuring there is a large spacing between the lead wires of the two adjacent center current collectors 1, thereby preventing the problem of short circuit caused by contact between two adjacent lead wires.

By the above layout, as shown in FIG. 5, in the first direction X, the spacing L1 between two adjacent center current collectors 1 ranges from 15 mm to 25 mm, which may be, for example, 15 mm to 18 mm, or 18 mm to 20 mm, or 20 mm to 22 mm, or 22 mm to 25 mm. As an example, L1 is 15 mm, 16 mm, 17 mm, 18 mm, 19 mm, 20 mm, 21 mm, 22 mm, 23 mm, 24 mm, or 25 mm, or other value within the above range, which is not limited in the present disclosure. When L1 ranges from 15 mm to 25 mm, there is a larger space provided for the lead wires of the two adjacent center current collectors 1, thereby reducing the risk of short circuit. In addition, the total length of the center current collector 1 is reduced, saving materials, and reducing the shading of the center current collector 1 on light, thereby facilitating improvement of the output power of the photovoltaic module. In addition, when there is a large spacing between adjacent lead wires, an insulating material for insulation is not required, which facilitates saving materials and reduction of the production cost and process difficulty of the photovoltaic module, thereby improving the production efficiency of the photovoltaic module.

In some embodiments, as shown in FIG. 5, the solar cell 2 has a chamfer edge and a right-angled edge arranged opposite in the second direction Y. The chamfer edge of the first end solar cell 201 is arranged opposite to the chamfer edge of the third end solar cell 203, and the chamfer edge of the second end solar cell 202 is arranged opposite to the chamfer edge of the fourth end solar cell 204. That is, the chamfer edges of the first end solar cell 201, the second end solar cell 202, the third end solar cell 203, and the fourth end solar cell 204 are all arranged toward the lead wire, thereby providing more arrangement space for the lead wires, and further reducing the risk of contact between two adjacent lead wires. In addition, by such arrangement, the aesthetic appearance of the layout of the photovoltaic module can be improved.

In some embodiments, as shown in FIG. 3 and FIG. 5, the chamfer edges of a plurality of the solar cells 2 in the same solar cell string are arranged parallel. When the chamfer edges of a plurality of the solar cells 2 in the same solar cell string have a consistent direction, the solder strip 3 has a consistent contact area with the edges of each solar cell 2 in the same solar cell string, which facilitates reducing the risk of false soldering. In addition, the edges of the each solar cell 2 are subjected to a more uniform pressure, which facilitates reducing the fragmentation rate during the string soldering or the laminating, thereby improving the yield of the photovoltaic module. Furthermore, when the chamfer edges of a plurality of the solar cells 2 in the same solar cell string have a consistent direction, if the photovoltaic module is installed at an inclination, the risk of mutual shielding by the edge shadows of adjacent solar cells 2 is reduced, which facilitates improvement of the output power of the photovoltaic module.

Further, since the chamfer edge of the first end solar cell 201 is arranged opposite to the chamfer edge of the third end solar cell 203, and the chamfer edge of the second end solar cell 202 is arranged opposite to the chamfer edge of the fourth end solar cell 204, the photovoltaic module structure shown in FIG. 2 and FIG. 5 is obtained. That is, the chamfer edge of the solar cell 2 in the first solar cell string 10 and the chamfer edge of the solar cell 2 in the second solar cell string 20 are arranged parallel, and the chamfer edge of the solar cell 2 in the third solar cell string 30 and the chamfer edge of the solar cell 2 in the fourth solar cell string 40 are arranged parallel, that is, the chamfer edges of any two adjacent solar cells 2 in the first direction X are arranged parallel. When the chamfer edge of the solar cell 2 in the first solar cell string 10 and the chamfer edge of the solar cell 2 in the second solar cell string 20 are arranged parallel, it facilitates the quick alignment between the first solar cell string 10 and the second solar cell string 20, thereby improving the assembly efficiency of the photovoltaic module. In addition, when the chamfer edges of the solar cells 2 in the first solar cell string 10 and the chamfer edges of the solar cells 2 in the second solar cell string 20 have a consistent direction, the edges of two adjacent solar cells 2 in the first direction X is ensured to be subjected to an uniform stress during the laminating or as being impacted, thereby facilitating reducing the risk of microcrack or breakage of the solar cell 2, and further facilitating improving the yield and service life of the photovoltaic module.

In the same way, when the chamfer edges of the solar cells 2 in the third solar cell string 30 and the chamfer edges of the solar cells 2 in the fourth solar cell string 40 are arranged parallel, it facilitates quick alignment between the third solar cell string 30 and the fourth solar cell string 40, thereby improving the assembly efficiency of the photovoltaic module. In addition, when the chamfer edges of the solar cells 2 in the third solar cell string 30 and the chamfer edges of the solar cells 2 in the fourth solar cell string 40 have a consistent direction, which ensures that the edges of two adjacent solar cells 2 in the first direction X are subjected to an uniform stress during the laminating or as being impacted, thereby facilitating reducing the risk of microcrack or breakage of the solar cell 2, and further facilitating improving the yield and service life of the photovoltaic module.

When the chamfer edges of the solar cells 2 in the first solar cell string 10 and the chamfer edges of the solar cells 2 in the second solar cell string 20 are arranged parallel, and the chamfer edges of the solar cells 2 in the third solar cell string 30 and the chamfer edges of the solar cells 2 in the fourth solar cell string 40 are arranged parallel, the assembly efficiency, yield, and service life of the photovoltaic module are improved, as well as the regularity of the layout structure of the photovoltaic module is improved, and the aesthetic appearance is improved.

In addition, at this time, the chamfer edges of the solar cells 2 in the first solar cell string 10 are arranged opposite to the chamfer edges of the solar cells 2 in the third solar cell string 30, and the chamfer edges of the solar cells 2 in the second solar cell string 20 are arranged opposite to the chamfer edges of the solar cells 2 in the fourth solar cell string 40. When the chamfer edges of the solar cells 2 in the first solar cell string 10 are arranged opposite to the chamfer edges of the solar cells 2 in the third solar cell string 30, the arrangement of the solar cells 2 in the first solar cell string 10 and the arrangement of the solar cells 2 in the third solar cell string 30 are symmetrical with respect to the center current collector 1, which not only improves the aesthetic appearance of the photovoltaic module, but also ensures that the first end solar cell 201 and the third end solar cell 203 is subjected to more uniform stress during respectively connecting the first end solar cell 201 and the third end solar cell 203 to the center current collector 1 through the solder strip 3, thereby reducing the risk of false soldering or missing soldering, and the risk of microcrack and breakage of the first end solar cell 201 and the third end solar cell 203.

In the same way, when the chamfer edges of the solar cells 2 in the second solar cell string 20 are arranged opposite to the chamfer edges of the solar cells 2 in the fourth solar cell string 40, the arrangement of the solar cells 2 in the second solar cell string 20 and the arrangement of the solar cells 2 in the fourth solar cell string 40 are symmetrical with respect to the center current collector 1, which not only improves the aesthetic appearance of the photovoltaic module, but also ensures that the second end solar cell 202 and the fourth end solar cell 204 is subjected to more uniform stress during respectively connecting the second end solar cell 202 and the fourth end solar cell 204 to the center current collector 1 through the solder strip 3, thereby reducing the risk of false soldering and missing soldering, and the risk of microcrack and breakage of the second end solar cell 202 and the fourth end solar cell 204.

When the chamfer edges of the solar cells 2 in the first solar cell string 10 are arranged opposite to the chamfer edges of the solar cells 2 in the third solar cell string 30, and the chamfer edges of the solar cells 2 in the second solar cell string 20 are arranged opposite to the chamfer edges of the solar cells 2 in the fourth solar cell string 40, it facilitates further improvement of the yield and output power of the photovoltaic module.

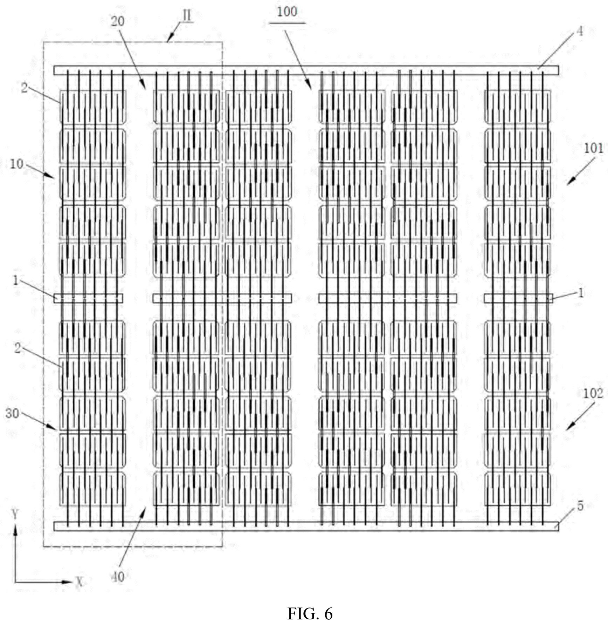

In some embodiments, as shown in FIG. 6, the chamfer edges of a plurality of the solar cells 2 in the same solar cell string are not arranged parallel, which omits the rotation process of some solar cells 2 during the production of the photovoltaic module, facilitating reduction of the production difficulty of the photovoltaic module and improvement of the production efficiency of the photovoltaic module.

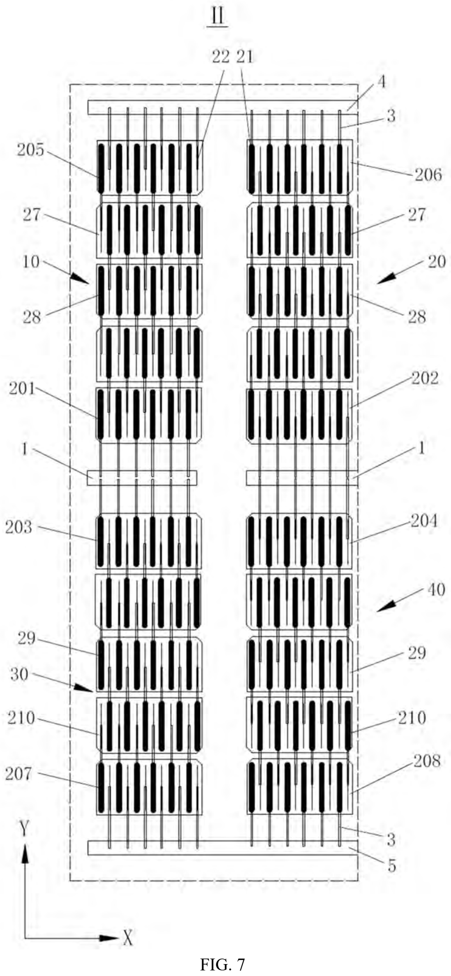

Referring to FIG. 7, the chamfer edges of any two adjacent solar cells 2 in the first direction X are arranged parallel, which ensures that the edges of two adjacent solar cells 2 in the first direction X are subjected to an uniform stress during the laminating or as being impacted, thereby facilitating reducing the risk of microcrack or breakage of the solar cell 2, and further facilitating improving the yield and service life of the photovoltaic module. In addition, when the chamfer edges of any two adjacent solar cells 2 in the first direction X are arranged parallel, chamfers of two solar cells 2, adjacent in the first direction X, of the first solar cell string 10 and the second solar cell string 20 have a consistent direction, and chamfers of two solar cells 2, adjacent in the first direction X, of the third solar cell string 30 and the fourth solar cell string 40 have a consistent direction, which facilitates the rapid alignment between the first solar cell string 10 and the second solar cell string 20 and the rapid alignment between the third solar cell string 30 and the fourth solar cell string 40, thereby improving the assembly efficiency of the photovoltaic module.

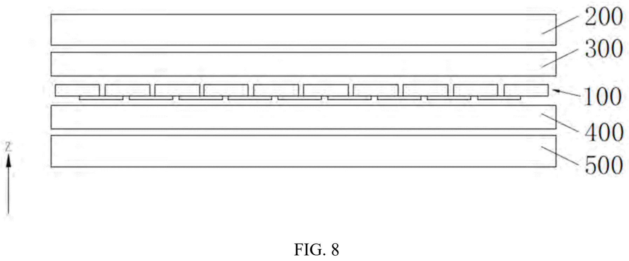

In some embodiments, as shown in FIG. 8, the photovoltaic module further includes a front sheet 200, a front encapsulation layer 300, a back encapsulation layer 400, and a back sheet 500. The front sheet 200 and the back sheet 500 jointly clamp the front encapsulation layer 300, the solar cell module 100, and the back encapsulation layer 400, and the photovoltaic module is formed through lamination and encapsulation. The front encapsulation layer 300 serves to protect the light-facing surface of the solar cell module 100, and the back encapsulation layer 400 serves to protect the backlight surface of the solar cell module 100. In addition, during the laminating of the photovoltaic module, the front encapsulation layer 300 and the back encapsulation layer 400 serve to encapsulate and protect the solar cell module 100, so as to prevent the external environment from affecting the performance of the solar cell module 100, and to bond the front sheet 200, the back sheet 500, and the solar cell module 100 into a whole.

The materials of the front sheet 200 and the back sheet 500 may be one of the rigid materials such as tempered glass, Polyethylene Terephthalate (PET), Polycarbonate (PC), etc., or one of the flexible materials such as Polyvinyl Fluoride (PVF), Ethylene-Tetra-FluoroEthylene (ETFE), and Polyvinylidene Fluoride (PVDF), etc. The front encapsulation layer 300 and the back encapsulation layer 400 are adhesive films. The material of the adhesive film may be one of the materials such as ethylene-vinyl acetate (EVA) copolymer, polyolefin elastomer (POE), polyvinyl butyral (PVB), etc., and the front encapsulation layer 300 and the back encapsulation layer 400 may also be an EPE adhesive film (EVA-POE-EVA co-extrusion structure) or EP adhesive film (EVA-EP co-extrusion structure).

In some embodiments, the photovoltaic module further includes a junction box (not shown in the drawings) arranged on the outside of the back sheet 500. The junction box is provided with a diode therein, and both ends of the diode are connected in reverse-parallel with the solar cell string through lead wires, to prevent damaging the photovoltaic module caused by exceeding a reverse bias limit of the solar cell.

In some embodiments, when the solar cell 2 is a back contact solar cell, the type of the solar cell 2 may be one of an Interdigitated Back Contact (IBC) solar cell, a Heterojunction Back Contact (HBC) solar cell, and a Tunnel Oxide Back Contact (TBC) solar cell.

For the IBC solar cell, in the thickness direction thereof, the IBC solar cell includes a silicon nitride anti-layer, an N+ front surface field, an N-type substrate silicon layer, a P+ emitter, an N+ back field, an aluminum oxide passivation layer, a silicon nitride anti-reflection layer, and a metal silver electrode in sequence. The IBC solar cell obtains a P-region and an N-region with good uniformity and precisely controllable junction depth by using an ion implantation technology. The front surface of the solar cell is free of grid lines shading, which eliminates the shading current loss of the metal electrode, and realizes the maximum utilization of incident photons, so that the short circuit current is increased by about 7% compared with the conventional solar cell. Due to the back contact structure, the problem of grid lines shading does not need to be considered, and the proportion of the grid lines is appropriately widened, thereby reducing the series resistance, and achieving a high fill factor. The surface passivation and surface light trapping structures are optimally designed to obtain a relatively low front surface recombination rate and surface reflection.

For the HBC solar cell, it well combines the advantages of the IBC solar cell and the heterojunction solar cell. Its front surface passivation layer adopts hydrogenated amorphous silicon, and N-type and P-type amorphous silicon thin films are respectively deposited on its back surface to form a heterojunction. The HBC solar cell utilizes fully the excellent surface passivation performance of the amorphous silicon, and the heterojunction structure formed on the back surface has a good passivation effect, which simultaneously achieve higher short circuit current and open circuit voltage, thereby improving the photoelectric conversion efficiency.

For the TBC solar cell, it has both the advantages of the tunnel oxide layer technology of Tunnel Oxide Passivated Contact (TOPCon) and the back surface arrangement electrode of IBC, significantly improving the passivation effect and open circuit voltage, which achieves higher solar cell conversion efficiency while maintaining cost-effectiveness. The complete production process of the TBC solar cell mainly includes depositing a tunneling oxide layer and P+ polysilicon, depositing a passivation film, and printing an electrode on the back surface of the silicon wafer. On the basis of the TOPCon production process, the TBC solar cell needs to add back-electrode-related processes such as masking, laser grooving, PN-region preparation, and etching. The masking is mainly completed by Atmospheric Pressure Chemical Vapor Deposition (APCVD) or Plasma-Enhanced Chemical Vapor Deposition (PECVD); the PN-region preparation is mainly completed by PECVD; the etching mainly adopts a conventional wet processing equipment; and the grooving process needs to be completed by a laser equipment.

In some embodiments, when the solar cell 2 is a back contact tandem solar cell, the solar cell 2 includes a back contact bottom solar cell and a perovskite top solar cell, where the perovskite top solar cell is electrically connected to the light-facing surface of the back contact bottom solar cell. The back contact bottom solar cell may be one of the interdigitated back contact solar cell, the heterojunction back contact solar cell, and the tunnel oxide back contact solar cell described above. The perovskite top solar cell is a thin film solar cell with a perovskite material as a photoactive layer. The structure of the perovskite top solar cell mainly consists of the following key components: a transparent conductive substrate, an electron transport layer, a perovskite light-absorbing layer, a hole transport layer, and a metal electrode. These components cooperate to enable the perovskite top solar cell to efficiently absorb sunlight and convert the sunlight into electrical energy. The perovskite material in the perovskite light-absorbing layer has excellent light-absorption performance, which absorbs a broader spectral range and effectively converts short-wavelength spectra, enabling the perovskite top solar cell to have a high photoelectric conversion efficiency.

The solar cell 2 is a cut cell, which may be, for example, a half-cut cell, a three-cut cell, a four-cut cell, or an eight-cut cell, which is not limited in embodiments of the present disclosure. In the following, taking the solar cell 2 as a half-cut cell for example for illustration.

In some embodiments, as shown in FIG. 4, the chamfer size of the solar cell 2 is A×45°, where A satisfies 1 mm ≤ A ≤ 2 mm. That is, the solar cell 2 has a chamfer of 45° and a side length A ranging from 1 mm to 2 mm. As an example, A may be 1 mm to 1.2 mm, or 1.2 mm to 1.4 mm, or 1.4 mm to 1.6 mm, or 1.6 mm to 1.8 mm, or 1.8 mm to 2 mm. As an example, A may be 1 mm, 1.1 mm, 1.2 mm, 1.3 mm, 1.4 mm, 1.5 mm, 1.6 mm, 1.7 mm, 1.8 mm, 1.9 mm or 2 mm, or other value within the above range, which is not limited in the present disclosure. When A ranges from 1 mm to 2 mm, the production difficulty of the solar cell 2 is reduced, which facilitates the cutting for production and improves the yield and production efficiency of the solar cell 2. In addition, the edge reflection of the solar cell 2 is appropriately reduced, which facilitates improvement of the photoelectric conversion efficiency of the solar cell 2.

As shown in FIG. 5, the solder strip 3 includes a first solder strip 31, a second solder strip 32, a third solder strip 33, and a fourth solder strip 34. The first solder strip 31 serves to connect the center current collector 1 with the first busbar 21 of the first end solar cell 201. The second solder strip 32 serves to connect the center current collector 1 with the first busbar 21 of the third end solar cell 203. The third solder strip 33 serves to connect the center current collector 1 with the second busbar 22 of the second end solar cell 202. The fourth solder strip 34 serves to connect the center current collector 1 with the second busbar 22 of the fourth end solar cell 204.

In some embodiments, as shown in FIG. 5, the first solder strip 31 and the second solder strip 32 are aligned in the second direction Y, and/or the third solder strip 33 and the fourth solder strip 34 are aligned in the second direction Y. When the first solder strip 31 and the second solder strip 32 are aligned, they are on the same horizontal line to be more easily positioned, facilitating the arrangement and soldering of the first solder strip 31 and the second solder strip 32, thereby facilitating reduction of the production difficulty of the photovoltaic module and improvement of the production efficiency of the photovoltaic module. In the same way, when the third solder strip 33 and the fourth solder strip 34 are aligned, they are on the same horizontal line to be more easily positioned, facilitating the arrangement and soldering of the third solder strip 33 and the fourth solder strip 34, thereby facilitating reduction of the production difficulty of the photovoltaic module and improvement of the production efficiency of the photovoltaic module. When the first solder strip 31 and the second solder strip 32 are aligned, and the third solder strip 33 and the fourth solder strip 34 are aligned, it facilitates further reduction of the production difficulty of the photovoltaic module and improvement of the production efficiency of the photovoltaic module, and also facilitates improvement of the aesthetic appearance of the photovoltaic module.

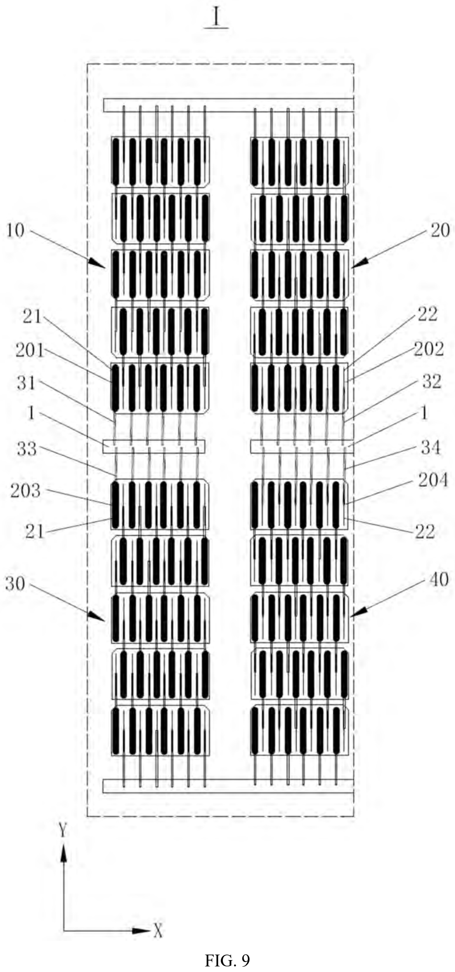

In some other embodiments, as shown in FIG. 9, the first solder strip 31 and the second solder strip 32 are staggered in the second direction Y, and/or the third solder strip 33 and the fourth solder strip 34 are staggered in the second direction Y. When the first solder strip 31 and the second solder strip 32 are staggered, the problem of increased local thickness formed by overlapping and contacting between the first solder strip 31 and the second solder strip 32 is prevented, thereby reducing the lamination difficulty, and facilitating improvement of the flatness of the solar cell module 100. In the same way, when the third solder strip 33 and the fourth solder strip 34 are staggered, the problem of increased local thickness formed by overlap of the third solder strip 33 and the fourth solder strip 34 is prevented, thereby reducing the lamination difficulty, and facilitating improvement of the flatness of the solar cell module 100. When the first solder strip 31 and the second solder strip 32 are staggered, and the third solder strip 33 and the fourth solder strip 34 are staggered, it facilitates further reduction of the lamination difficulty and improvement of the production efficiency and structural reliability of the photovoltaic module.

In some embodiments, as shown in FIG. 5, the photovoltaic module further includes a first edge current collector 4 extending in the first direction X. Ends, closed to the first edge current collector 4, of the first solar cell string 10 and the second solar cell string 20 respectively have a fifth end solar cell 205 and a sixth end solar cell 206. The second busbar 22 of the fifth end solar cell 205 and the first busbar 21 of the sixth end solar cell 206 are respectively connected to the first edge current collector 4 through the solder strip 3. That is, the first solar cell string 10 and the second solar cell string 20 form a series connection through the first edge current collector 4. In the same way, as shown in FIG. 5, the photovoltaic module further includes a second edge current collector 5 extending in the first direction X. The second edge current collector 5 and the first edge current collector 4 are arranged opposite in the second direction Y. Ends, closed to the second edge current collector 5, of the third solar cell string 30 and the fourth solar cell string 40 respectively have a seventh end solar cell 207 and an eighth end solar cell 208. The second busbar 22 of the seventh end solar cell 207 and the first busbar 21 of the eighth end solar cell 208 are respectively connected to the second edge current collector 5 through the solder strip 3. That is, the third solar cell string 30 and the fourth solar cell string 40 form a series connection through the second edge current collector 5.

In some embodiments, as shown in FIG. 4, the spacing L2 between adjacent first busbar 21 and second busbar 22 of the same solar cell 2 ranges from 8 mm to 9.5 mm. As an example, L2 may be 8 mm to 8.5 mm, or 8.5 mm to 9 mm, or 9 mm to 9.5 mm. As an example, L2 may be 8 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm or 9.5 mm, or other value within the above range, which is not limited in the present disclosure. When L2 ranges from 8 mm to 9.5 mm, the risk of short circuit caused by diffusion or printing deviation in the metallization process is reduced, thereby facilitating improvement of the yield of the solar cell 2 and reduction of the production cost of the photovoltaic module. In addition, the appropriate spacing is beneficial to ensure efficient collection of the photogenerated carriers, and to improve the heat dissipation effect of the solar cell 2, thereby being beneficial to improve the photoelectric conversion efficiency of the solar cell 2 and prolong the service life of the solar cell 2. A sum of numbers of the first busbars 21 and the second busbars 22 of the solar cell 2 ranges from 8 to 30, and the sum may be odd or even.

In some embodiments, the sum of numbers of the first busbars 21 and the second busbars 22 is even. That is, the number of the first busbars 21 and the number of the second busbars 22 are equal. As an example, the sum of numbers of the first busbars 21 and the second busbars 22 is 8 to 16, 16 to 20, 20to 26, or 26 to 30. As an example, the sum of numbers of the first busbars 21 and the second busbars 22 is 8, 10, 12, 14, 16, 18, 20, 22, 24, 26, 28 or 30, or other value within the above range, which is not limited in the present disclosure.

When the chamfer edges of a plurality of the solar cells 2 in the same solar cell string are arranged parallel, as shown in FIG. 3, when the sum of numbers of the first busbars 21 and the second busbars 22 of the solar cell 2 is even, the solar cells 2 in the same solar cell string includes two types of the solar cell of a first solar cell 23 and a second solar cell 24. The first solar cell 23 and the second solar cell 24 are arranged alternately in the second direction Y. One of the first solar cell 23 and the second solar cell 24 has a structure that is symmetrical to a 180° rotated structure of the other one. The first solar cell 23 and the second solar cell 24 are two half-cut cells of the same solar cell, which reduces the amount of original solar cells required for manufacturing a photovoltaic module, thereby reducing the production cost of the photovoltaic module.

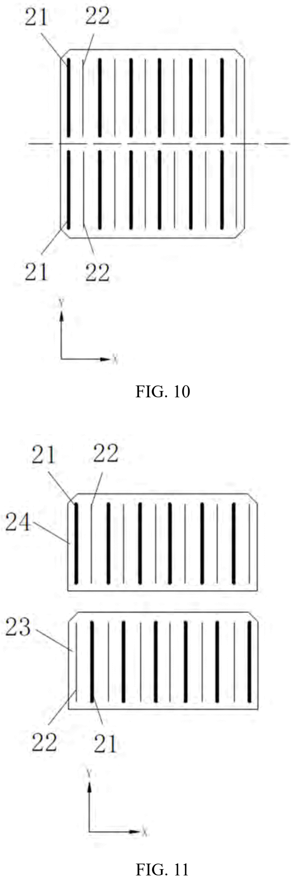

Referring to FIG. 10, the original solar cell has a center line (shown by the dashed line in FIG. 10) in the second direction X, and the original solar cell includes an upper part and a lower part that are symmetric with respect to the center line. The upper solar cell and the lower solar cell are respectively provided with a first busbar 21 and a second busbar 22 arranged alternately in the first direction X. The first busbar 21 of the upper solar cell and the first busbar 21 of the lower solar cell are aligned in the second direction Y, and the second busbar 22 of the upper solar cell and the second busbar 22 of the lower solar cell are aligned in the second direction Y. By cutting along the center line, two half-cut cells are obtained. Rotating one of the two half-cut cells by 180° obtains two half-cut cells with a consistent chamfer direction as shown in FIG. 11, where one of the two half-cut cells is the first solar cell 23 in these embodiments, and the other one is the second solar cell 24 in these embodiments.

The original solar cell may be a rectangular solar cell or a square solar cell, which is not limited in the present disclosure.

As shown in FIG. 5, in the first embodiment, the sum of numbers of the first busbars 21 and the second busbars 22 of the solar cells 2 is even, and the number of the solar cells 2 in each of the first solar cell string 10, the second solar cell string 20, the third solar cell string 30, and the fourth solar cell string 40 is odd. As an example, the number of the solar cells 2 in each solar cell string is 9, 11, 13, 15, 17, 19 or 21. The numbers of the solar cells 2 in multiple solar cell strings should be consistent to ensure the neatness of the layout of the photovoltaic module.

In this embodiment, the edge busbar, adjacent to the sixth end solar cell 206, of the fifth end solar cell 205 and the edge busbar, adjacent to the eighth end solar cell 208, of the seventh end solar cell 207 are both the second busbar 22. The edge busbar, adjacent to the fifth end solar cell 205, of the sixth end solar cell 206 and the edge busbar, adjacent to the seventh end solar cell 207, of the eighth end solar cell 208 are both the first busbar 21. Since the second busbar 22 of the fifth end solar cell 205 and the first busbar 21 of the sixth end solar cell 206 are both connected to the first edge current collector 4, the edge busbar, adjacent to the sixth end solar cell 206, of the fifth end solar cell 205 and the edge busbar, adjacent to the fifth end solar cell 205, of the sixth end solar cell 206 are both connected to the first edge current collector 4. Since the second busbar 22 of the seventh end solar cell 207 and the first busbar 21 of the eighth end solar cell 208 are both connected to the second edge current collector 5, the edge busbar, adjacent to the eighth end solar cell 208, of the seventh end solar cell 207 and the edge busbar, adjacent to the seventh end solar cell 207, of the eighth end solar cell 208 are both connected to the second edge current collector 5.

The spacing L3 between the edge busbar, adjacent to the sixth end solar cell 206, of the fifth end solar cell 205 and the edge busbar, adjacent to the fifth end solar cell 205, of the sixth end solar cell 206 ranges from 1 mm to 2.5 mm. As an example, L3 may be 1 mm to 1.5 mm, or 1.5 mm to 2 mm, or 2 mm to 2.5 mm. As an example, L3 may be 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm or 2.5 mm, or other value within the above range, which is not limited in the present disclosure. When L3 ranges from 1 mm to 2.5 mm, there is an appropriate string spacing maintained between the first solar cell string 10 and the second solar cell string 20, preventing overlapping and contacting between the solder strip 3 at the edge busbar of the fifth end solar cell 205 and the solder strip 3 at the edge busbar of the sixth end solar cell 206 caused by the too small spacing, thereby reducing the risk of stress concentration at the edges of the fifth end solar cell 205 and the sixth end solar cell 206, and reducing the risk of short circuit caused by overlapping and contacting of the solder strips 3 with opposite polarities. In addition, the appropriate string spacing is also conducive to increasing the overall light-receiving area of the photovoltaic module, thereby improving the output power of the photovoltaic module.

In the same way, the spacing L4 between the edge busbar, adjacent to the eighth end solar cell 208, of the seventh end solar cell 207 and the edge busbar, adjacent to the seventh end solar cell 207, of the eighth end solar cell 208 ranges from 1 mm to 2.5 mm. As an example, L4 may be 1 mm to 1.5 mm, or 1.5 mm to 2 mm, or 2 mm to 2.5 mm. As an example, L4 may be 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm or 2.5 mm, or other value within the above range, which is not limited in the present disclosure. When L4 ranges from 1 mm to 2.5 mm, there is an appropriate string spacing maintained between the third solar cell string 30 and the fourth solar cell string 40, preventing overlapping and contacting between the solder strip 3 at the edge busbar of the seventh end solar cell 207 and the solder strip 3 at the edge busbar of the eighth end solar cell 208 caused by the too small spacing, thereby reducing the risk of stress concentration at the edges of the seventh end solar cell 207 and the eighth end solar cell 208 and reducing the risk of short circuit caused by overlapping and contacting of the solder strips 3 with opposite polarities. In addition, the appropriate string spacing is also conducive to increasing the overall light-receiving area of the photovoltaic module, thereby improving the output power of the photovoltaic module.

When L3 is equal to L4, it ensures that the first solar cell string 10 and the third solar cell string 30 are aligned in the second direction Y, and the second solar cell string 20 and the fourth solar cell string 40 are aligned in the second direction Y, which facilitates layout and assembly of the photovoltaic module and improvement of the aesthetic appearance of the photovoltaic module.

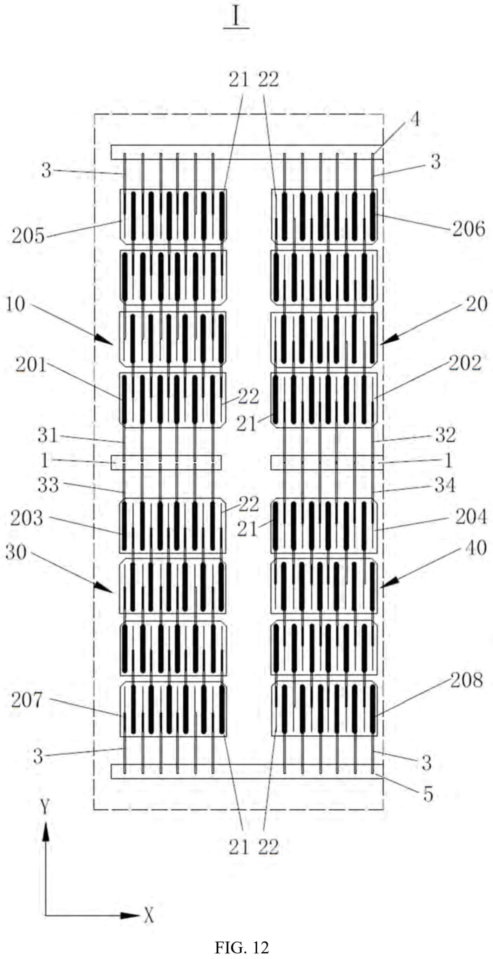

As shown in FIG. 12, in the second embodiment, the sum of numbers of the first busbars 21 and the second busbars 22 of the solar cells 2 is even, and the number of the solar cells 2 in each of the first solar cell string 10, the second solar cell string 20, the third solar cell string 30, and the fourth solar cell string 40 is even. As an example, the number of the solar cells 2 in each solar cell string is 8, 10, 12, 14, 16, 18, or 20. The numbers of the solar cells 2 in multiple solar cell strings should be consistent to ensure the neatness of the layout of the photovoltaic module.

In this embodiment, the edge busbar, adjacent to the sixth end solar cell 206, of the fifth end solar cell 205 and the edge busbar, adjacent to the eighth end solar cell 208, of the seventh end solar cell 207 are both the first busbar 21. The edge busbar, adjacent to the fifth end solar cell 205, of the sixth end solar cell 206 and the edge busbar, adjacent to the seventh end solar cell 207, of the eighth end solar cell 208 are both the second busbar 22. Since the second busbar 22 of the fifth end solar cell 205 and the first busbar 21 of the sixth end solar cell 206 are both connected to the first edge current collector 4, the edge busbar, adjacent to the sixth end solar cell 206, of the fifth end solar cell 205 and the edge busbar, adjacent to the fifth end solar cell 205, of the sixth end solar cell 206 are both not connected to the first edge current collector 4. Since the second busbar 22 of the seventh end solar cell 207 and the first busbar 21 of the eighth end solar cell 208 are both connected to the second edge current collector 5, the edge busbar, adjacent to the eighth end solar cell 208, of the seventh end solar cell 207 and the edge busbar, adjacent to the seventh end solar cell 207, of the eighth end solar cell 208 are both not connected to the second edge current collector 5.

When neither the edge busbar, adjacent to the sixth end solar cell 206, of the fifth end solar cell 205 nor the edge busbar, adjacent to the fifth end solar cell 205, of the sixth end solar cell 206 is connected to the first edge current collector 4, the risk of overlapping and contacting between the solder strip 3 at the edge busbar of the fifth end solar cell 205 and the solder strip 3 at the edge busbar of the sixth end solar cell 206 is reduced, thereby reducing the risk of stress concentration at the edges of the fifth end solar cell 205 and the sixth end solar cell 206, and reducing the risk of short circuit caused by overlapping and contacting of the solder strips 3 with opposite polarities.

In the same way, when neither the edge busbar, adjacent to the eighth end solar cell 208, of the seventh end solar cell 207 nor the edge busbar, adjacent to the seventh end solar cell 207, of the eighth end solar cell 208 is connected to the second edge current collector 5, the risk of overlapping and contacting between the solder strip 3 at the edge busbar of the seventh end solar cell 207 and the solder strip 3 at the edge busbar of the eighth end solar cell 208 is reduced, thereby reducing the risk of stress concentration at the edges of the seventh end solar cell 207 and the eighth end solar cell 208 and reducing the risk of short circuit caused by overlapping and contacting of the solder strips 3 with opposite polarities.

When the chamfer edges of a plurality of the solar cells 2 in the same solar cell string are not arranged parallel, as shown in FIG. 7, when the sum of numbers of the first busbars 21 and the second busbars 22 of the solar cell 2 is even, the solar cells 2 in the same solar cell string includes two types of the solar cell of a fifth solar cell 27 and a sixth solar cell 28. The fifth solar cell 27 and the sixth solar cell 28 are arranged alternately in the second direction Y. The fifth solar cell 27 and the sixth solar cell 28 are two half-cut cells of the same solar cell. The first busbar 21 of the fifth solar cell 27 and the second busbar 22 of the sixth solar cell 28 are aligned in the second direction Y, and the second busbar 22 of the fifth solar cell 27 and the first busbar 21 of the sixth solar cell 28 are aligned in the second direction Y. Alternatively, the solar cells 2 in the same solar cell string includes two types of the solar cell of a seventh solar cell 29 and an eighth solar cell 210. The seventh solar cell 29 and the eighth solar cell 210 are arranged alternately in the second direction Y. The seventh solar cell 29 and the eighth solar cell 210 are two half-cut cells of the same solar cell. The first busbar 21 of the seventh solar cell 29 and the second busbar 22 of the eighth solar cell 210 are aligned in the second direction Y, and the second busbar 22 of the seventh solar cell 29 and the first busbar 21 of the eighth solar cell 210 are aligned in the second direction Y.

As shown in FIG. 7, in the first embodiment, when the number of the solar cells 2 in each of the first solar cell string 10, the second solar cell string 20, the third solar cell string 30, and the fourth solar cell string 40 is odd, the first end solar cell 201 and the second end solar cell 202 are both the sixth solar cell 28, and the third end solar cell 203 and the fourth end solar cell 204 are both the seventh solar cell 29. One of the fifth end solar cell 205 and the sixth end solar cell 206 is the fifth solar cell 27 rotated by 180°, and the other one is the sixth solar cell 28. One of the seventh end solar cell 207 and the eighth end solar cell 208 is the seventh solar cell 29, and the other one is the eighth solar cell 210 rotated by 180°. The remaining cells in the first solar cell string 10, the second solar cell string 20, the third solar cell string 30, and the fourth solar cell string 40 are arranged in the order shown in FIG. 7, which will not be repeated herein.

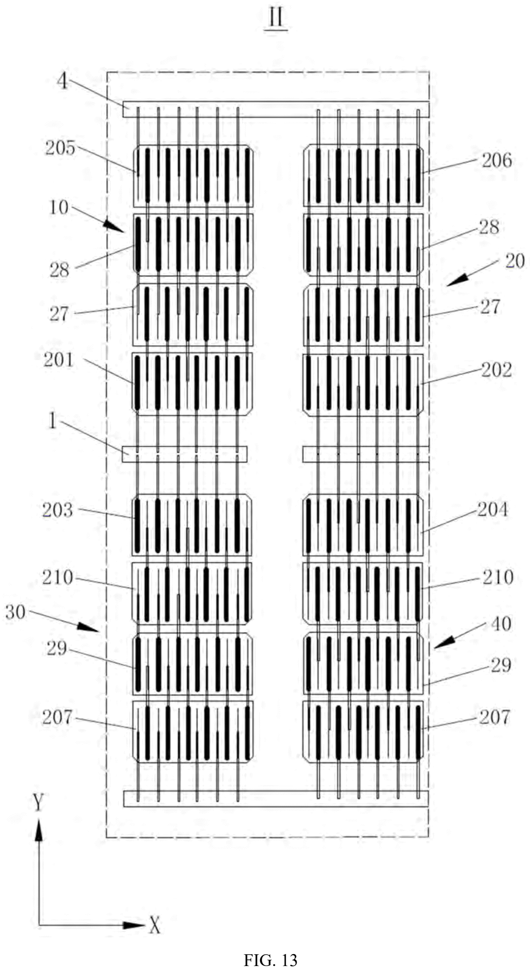

In the second embodiment, as shown in FIG. 13, when the number of the solar cells 2 in each of the first solar cell string 10, the second solar cell string 20, the third solar cell string 30, and the fourth solar cell string 40 is even, the first end solar cell 201 and the second end solar cell 202 are both the sixth solar cells 28, and the third end solar cell 203 and the fourth end solar cell 204 are both the seventh solar cells 29. The fifth end solar cell 205 and the sixth end solar cell 206 are both the fifth solar cells 27, and the seventh end solar cell 207 and the eighth end solar cell 208 are both the eighth solar cells 210. The remaining cells in the first solar cell string 10, the second solar cell string 20, the third solar cell string 30, and the fourth solar cell string 40 are arranged in the order shown in FIG. 13, which will not be repeated herein. In some embodiments, the sum of numbers of the first busbars 21 and the second busbars 22 is odd, that is, the number of the first busbars 21 and the number of the second busbars 22 are unequal. As an example, the sum of numbers of the first busbars 21 and he second busbars 22 is 9 to 15, 15 to 21, 21to 25, or 25 to 29. As an example, the sum of numbers of the first busbars 21 and the second busbars 22 is 9, 11, 13, 15, 17, 19, 21, 23, 25, 27 or 29, or other values within the above range, which is not limited in the present disclosure.

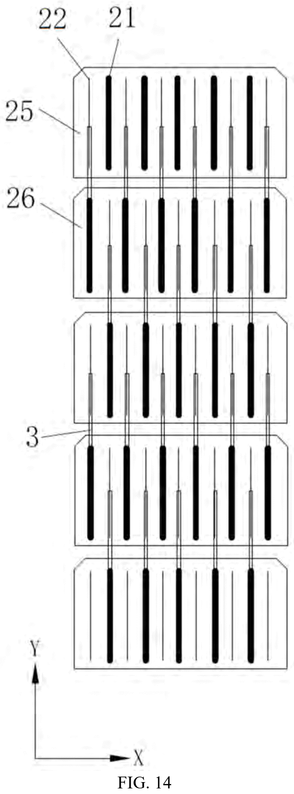

When the chamfer edges of a plurality of the solar cells 2 in the same solar cell string are arranged parallel, as shown in FIG. 14, when the sum of numbers of the first busbars 21 and the second busbars 22 of the solar cell 2 is odd, the solar cells 2 in the same solar cell string includes two types of the solar cell of a third solar cell 25 and a fourth solar cell 26. The third solar cell 25 and the fourth solar cell 26 are arranged alternately in the second direction Y. The third solar cell 25 and the fourth solar cell 26 are two half-cut cells of the same solar cell, which reduces the amount of original solar cells required for manufacturing a photovoltaic module, thereby reducing the production cost of the photovoltaic module.

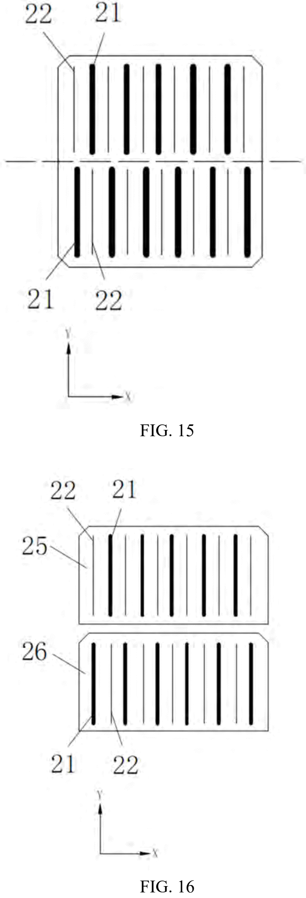

Referring to FIG. 15, the original solar cell has a center line (shown by the dashed line in FIG. 15) in the second direction X, and the original solar cell includes an upper part and a lower part that are symmetric with respect to the center line. The upper solar cell and the lower solar cell are respectively provided with a first busbar 21 and a second busbar 22 arranged alternately in the first direction X. The first busbar 21 of the upper solar cell and the second busbar 22 of the lower solar cell are aligned in the second direction Y, and the second busbar 22 of the upper solar cell and the first busbar 21 of the lower solar cell are aligned in the second direction Y. By cutting along the center line, two half-cut cells are obtained. Rotating one of the two half-cut cells by 180° obtains two half-cut cells with a consistent chamfer direction as shown in FIG. 11, where one of the two half-cut cells is third solar cell 25 in these embodiments, and the other one is the fourth solar cell 26 in these embodiments.

The original solar cell may be a rectangular solar cell or a square solar cell, which is not limited in the present disclosure.

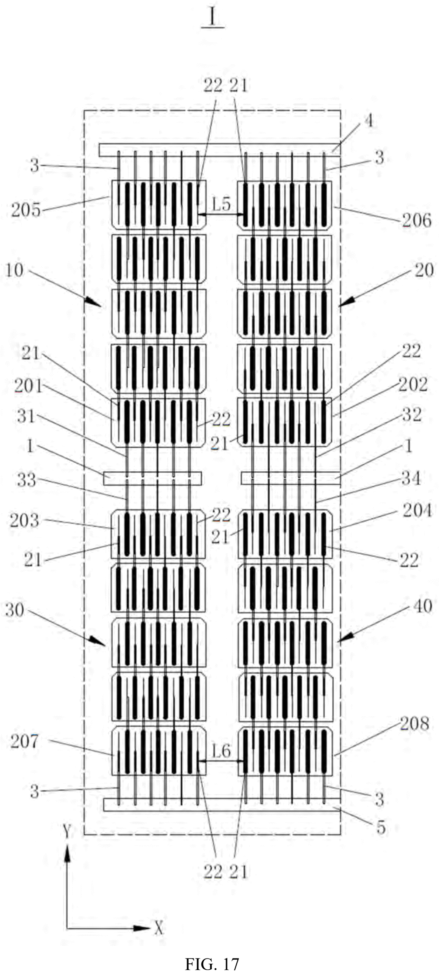

As shown in FIG. 17, in the third embodiment, the sum of numbers of the first busbars 21 and the second busbars 22 of the solar cells 2 is odd, and the number of the solar cells 2 in each of the first solar cell string 10, the second solar cell string 20, the third solar cell string 30, and the fourth solar cell string 40 is odd. As an example, the number of the solar cells 2 in each solar cell string is 9, 11, 13, 15, 17, 19 or 21. The numbers of the solar cells 2 in multiple solar cell strings should be consistent to ensure the neatness of the layout of the photovoltaic module.

In this embodiment, the edge busbar, adjacent to the sixth end solar cell 206, of the fifth end solar cell 205 and the edge busbar, adjacent to the eighth end solar cell 208, of the seventh end solar cell 207 are both the second busbars 22. The edge busbar, adjacent to the fifth end solar cell 205, of the sixth end solar cell 206 and the edge busbar, adjacent to the seventh end solar cell 207, of the eighth end solar cell 208 are both the first busbars 21. Since the second busbar 22 of the fifth end solar cell 205 and the first busbar 21 of the sixth end solar cell 206 are both connected to the first edge current collector 4, the edge busbar, adjacent to the sixth end solar cell 206, of the fifth end solar cell 205 and the edge busbar, adjacent to the fifth end solar cell 205, of the sixth end solar cell 206 are both connected to the first edge current collector 4. Since the second busbar 22 of the seventh end solar cell 207 and the first busbar 21 of the eighth end solar cell 208 are both connected to the second edge current collector 5, the edge busbar, adjacent to the eighth end solar cell 208, of the seventh end solar cell 207 and the edge busbar, adjacent to the seventh end solar cell 207, of the eighth end solar cell 208 are both connected to the second edge current collector 5.

The spacing L5 between the edge busbar, adjacent to the sixth end solar cell 206, of the fifth end solar cell 205 and the edge busbar, adjacent to the fifth end solar cell 205, of the sixth end solar cell 206 ranges from 1 mm to 2.5 mm. As an example, L5 may be 1 mm to 1.5 mm, or 1.5 mm to 2 mm, or 2 mm to 2.5 mm. As an example, L5 may be 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm or 2.5 mm, or other value within the above range, which is not limited in the present disclosure. When L5 ranges from 1 mm to 2.5 mm, there is an appropriate string spacing maintained between the first solar cell string 10 and the second solar cell string 20, preventing overlapping and contacting between the solder strip 3 at the edge busbar of the fifth end solar cell 205 and the solder strip 3 at the edge busbar of the sixth end solar cell 206 caused by the too small spacing, thereby reducing the risk of stress concentration at the edges of the fifth end solar cell 205 and the sixth end solar cell 206, and reducing the risk of short circuit caused by overlapping and contacting of the solder strips 3 with opposite polarities. In addition, the appropriate string spacing is also conducive to increasing the overall light-receiving area of the photovoltaic module, thereby improving the output power of the photovoltaic module.

In the same way, the spacing L6 between the edge busbar, adjacent to the eighth end solar cell 208, of the seventh end solar cell 207 and the edge busbar, adjacent to the seventh end solar cell 207, of the eighth end solar cell 208 ranges from 1 mm to 2.5 mm. As an example, L6 may be 1 mm to 1.5 mm, or 1.5 mm to 2 mm, or 2 mm to 2.5 mm. As an example, L6 may be 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm or 2.5 mm, or other value within the above range, which is not limited in the present disclosure. When L6 ranges from 1 mm to 2.5 mm, there is an appropriate string spacing maintained between the third solar cell string 30 and the fourth solar cell string 40, preventing overlapping and contacting between the solder strip 3 at the edge busbar of the seventh end solar cell 207 and the solder strip 3 at the edge busbar of the eighth end solar cell 208 caused by the too small spacing, thereby reducing the risk of stress concentration at the edges of the seventh end solar cell 207 and the eighth end solar cell 208 and reducing the risk of short circuit caused by overlapping and contacting of the solder strips 3 with opposite polarities. In addition, the appropriate string spacing is also conducive to increasing the overall light-receiving area of the photovoltaic module, thereby improving the output power of the photovoltaic module.

When L5 is equal to L6, it ensures that the first solar cell string 10 and the third solar cell string 30 are aligned in the second direction Y, and the second solar cell string 20 and the fourth solar cell string 40 are aligned in the second direction Y, which facilitates layout and assembly of the photovoltaic module and improvement of the aesthetic appearance of the photovoltaic module.

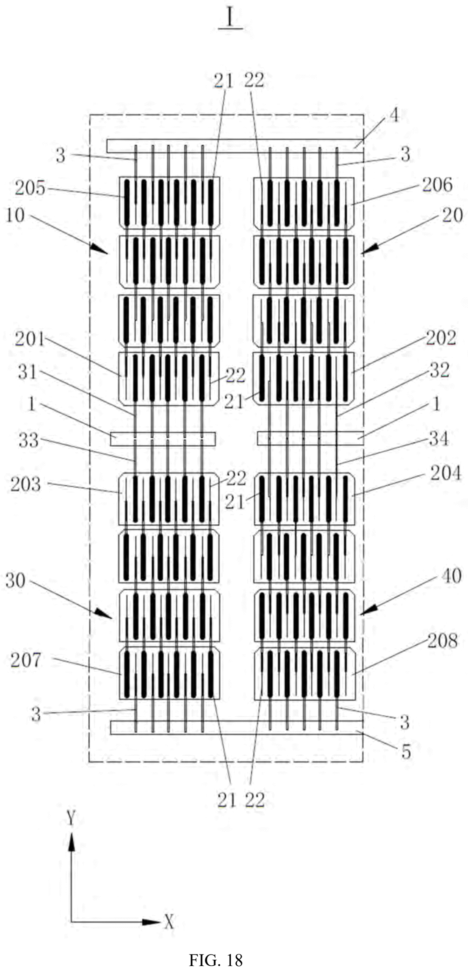

As shown in FIG. 18, in the second embodiment, the sum of numbers of the first busbars 21 and the second busbars 22 of the solar cells 2 is even, and the number of the solar cells 2 in each of the first solar cell string 10, the second solar cell string 20, the third solar cell string 30, and the fourth solar cell string 40 is even. As an example, the number of the solar cells 2 in each solar cell string is 8, 10, 12, 14, 16, 18, or 20. The numbers of the solar cells 2 in multiple solar cell strings should be consistent to ensure the neatness of the layout of the photovoltaic module.

In this embodiment, the edge busbar, adjacent to the sixth end solar cell 206, of the fifth end solar cell 205 and the edge busbar, adjacent to the eighth end solar cell 208, of the seventh end solar cell 207 are both the first busbars 21. The edge busbar, adjacent to the fifth end solar cell 205, of the sixth end solar cell 206 and the edge busbar, adjacent to the seventh end solar cell 207, of the eighth end solar cell 208 are both the second busbars 22. Since the second busbar 22 of the fifth end solar cell 205 and the first busbar 21 of the sixth end solar cell 206 are both connected to the first edge current collector 4, the edge busbar, adjacent to the sixth end solar cell 206, of the fifth end solar cell 205 and the edge busbar, adjacent to the fifth end solar cell 205, of the sixth end solar cell 206 are both not connected to the first edge current collector 4. Since the second busbar 22 of the seventh end solar cell 207 and the first busbar 21 of the eighth end solar cell 208 are both connected to the second edge current collector 5, the edge busbar, adjacent to the eighth end solar cell 208, of the seventh end solar cell 207 and the edge busbar, adjacent to the seventh end solar cell 207, of the eighth end solar cell 208 are both not connected to the second edge current collector 5.

When neither the edge busbar, adjacent to the sixth end solar cell 206, of the fifth end solar cell 205 nor the edge busbar, adjacent to the fifth end solar cell 205, of the sixth end solar cell 206 is connected to the first edge current collector 4, the risk of overlapping and contacting between the solder strip 3 at the edge busbar of the fifth end solar cell 205 and the solder strip 3 at the edge busbar of the sixth end solar cell 206 is reduced, thereby reducing the risk of stress concentration at the edges of the fifth end solar cell 205 and the sixth end solar cell 206, and reducing the risk of short circuit caused by overlapping and contacting of the solder strips 3 with opposite polarities.

In the same way, when neither the edge busbar, adjacent to the eighth end solar cell 208, of the seventh end solar cell 207 nor the edge busbar, adjacent to the seventh end solar cell 207, of the eighth end solar cell 208 is connected to the second edge current collector 5, the risk of overlapping and contacting between the solder strip 3 at the edge busbar of the seventh end solar cell 207 and the solder strip 3 at the edge busbar of the eighth end solar cell 208 is reduced, thereby reducing the risk of stress concentration at the edges of the seventh end solar cell 207 and the eighth end solar cell 208 and reducing the risk of short circuit caused by overlapping and contacting of the solder strips 3 with opposite polarities.

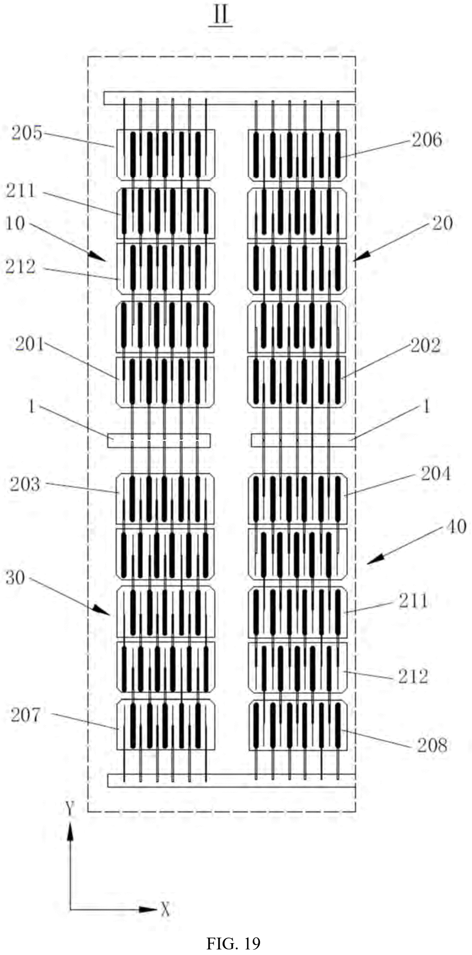

When the chamfer edges of a plurality of the solar cells 2 in the same solar cell string are not arranged parallel, as shown in FIG. 19, when the sum of numbers of the first busbars 21 and the second busbars 22 of the solar cell 2 is odd, the solar cells 2 in the same solar cell string includes two types of the solar cell of a ninth solar cell 211 and a tenth solar cell 212. The ninth solar cell 211 and the tenth solar cell 212 are arranged alternately in the second direction Y. The ninth solar cell 211 and the tenth solar cell 212 are two half-cut cells of the same solar cell. The first busbar 21 of the ninth solar cell 211 and the second busbar 22 of the tenth solar cell 212 are aligned in the second direction Y, and the second busbar 22 of the ninth solar cell 211 and the first busbar 21 of the tenth solar cell 212 are aligned in the second direction Y.

As shown in FIG. 19, in the first embodiment, when the number of the solar cells 2 in each of the first solar cell string 10, the second solar cell string 20, the third solar cell string 30, and the fourth solar cell string 40 is odd, the first end solar cell 201 and the fifth end solar cell 205 are both the tenth solar cells 212. The remaining solar cells in the first solar cell string 10 are the ninth solar cell 211 and the tenth solar cell 212 arranged alternately. The third solar cell string 30 is obtained by rotating the first solar cell string 10 by 180°. The fourth end solar cell 204 and the eighth end solar cell 208 are both the ninth solar cell 211. The remaining cells in the fourth solar cell string 40 are the ninth solar cell 211 and the tenth solar cell 212 arranged alternately. The second solar cell string 20 is obtained by rotating the fourth solar cell string 40 by 180°.

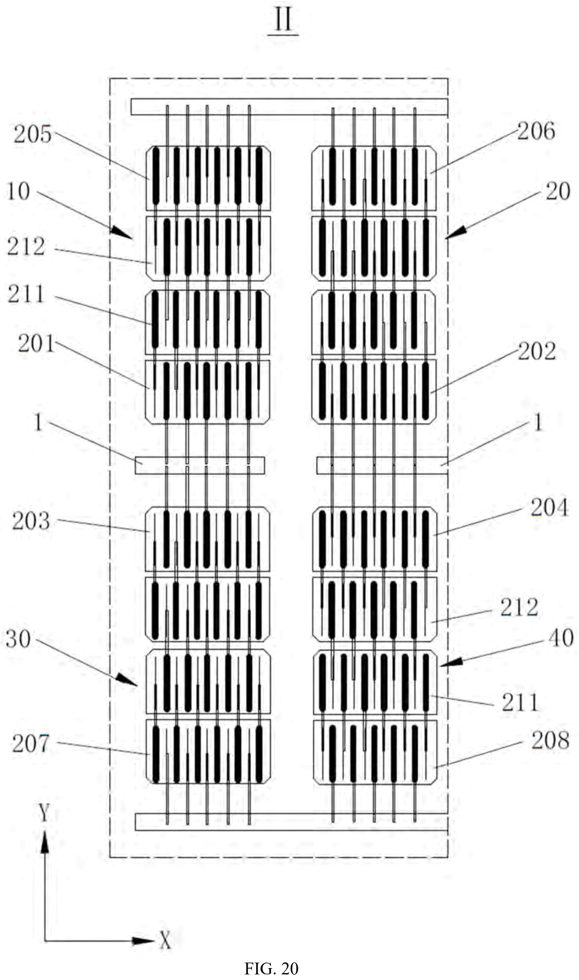

As shown in FIG. 20, in the second embodiment, when the number of the solar cells 2 in each of the first solar cell string 10, the second solar cell string 20, the third solar cell string 30, and the fourth solar cell string 40 is even, the first end solar cell 201 is the tenth solar cell 212, and the fifth end solar cell 205 is the ninth solar cell 211. The remaining cells in the first solar cell string 10 are the ninth solar cell 211 and the tenth solar cell 212 arranged alternately. The third solar cell string 30 is obtained by rotating the first solar cell string 10 by 180°. The fourth end solar cell 204 is the ninth solar cell 211, and the eighth end solar cell 208 is the tenth solar cell 212. The second solar cell string 20 is obtained by rotating the fourth solar cell string 40 by 180°.

One or more embodiments of the present disclosure further provides a method for manufacturing a photovoltaic module, to obtain the photovoltaic module described in the above embodiments, and the method specifically includes the following steps:
Step S1: providing a plurality of the solar cells 2, where the solar cells 2 include a first busbar 21 and a second busbar 22 spaced apart in a first direction X, and the solar cell 2 further has a chamfer edge.

In this step, the solar cell 2 selects a solar cell with a chamfer edge, which effectively reduces the risk of microcrack or breakage caused by stress concentration at the edge of the solar cell 2 and also reduces the edge reflection loss, thereby facilitating improvement of the photoelectric conversion efficiency of the solar cells 2.

Step S2: arranging the plurality of solar cells 2 in a second direction Y to respectively form a first solar cell string 10, a second solar cell string 20, a third solar cell string 30, and a fourth solar cell string 40, where the chamfer edges of the plurality of solar cells 2 in the same solar cell string are arranged parallel.

The solar cell strings are arranged, so that the chamfer edge of the first end solar cell 201 is arranged opposite to the chamfer edge of the third end solar cell 203, and the chamfer edge of the second end solar cell 202 is arranged opposite to the chamfer edge of the fourth end solar cell 204. The first solar cell string 10, the second solar cell string 20, the third solar cell string 30, and the fourth solar cell string 40 respectively have a first end solar cell 201, a second end solar cell 202, a third end solar cell 203, and a fourth end solar cell 204. The edge busbar, adjacent to the second end solar cell 202, of the first end solar cell 201 and the edge busbar, adjacent to the fourth end solar cell 204, of the third end solar cell 203 are both the second busbar 22. The edge busbar, adjacent to the first end solar cell 201, of the second end solar cell 202 and the edge busbar, adjacent to the third end solar cell 203, of the fourth end solar cell 204 are both the first busbar 21.

Connecting the first busbar 21 of the first end solar cell 201 and the first busbar 21 of the third end solar cell 203 to the same center current collector 1, and connecting the second busbar 22 of the second end solar cell 202 and the second busbar 22 of the third end solar cell 203 to another adjacent center current collector 1.

In this step, the first solar cell string 10, the second solar cell string 20, the third solar cell string 30, and the fourth solar cell string 40 are arranged, so that the edge busbar, closed to the lead wire, of any end solar cell is not electrically connected to the center current collector 1, so that there is sufficient space between two adjacent center current collectors 1 for providing the lead wire, ensuring there is a large spacing between the lead wires of the two adjacent center current collectors 1, thereby preventing the problem of short circuit caused by contact between two adjacent lead wires. In addition, when the chamfer edges of a plurality of the solar cells 2 in the same solar cell string have a consistent direction, the solder strip has a consistent contact area with the edges of each solar cell in the same solar cell string, which facilitates reducing the risk of false soldering of the solder strip 3. In addition, the chamfer edges of the first end solar cell 201, the second end solar cell 202, the third end solar cell 203, and the fourth end solar cell 204 are all arranged toward the lead wire, thereby providing more arrangement space for the lead wires, and further reducing the risk of contact between two adjacent lead wires. In addition, by such arrangement, the aesthetic appearance of the layout of the photovoltaic module can be improved.

In the following, taking the photovoltaic module shown in FIG. 2 as an example, that is, taking the following content as an example to introduce the above steps in detail: the solar cell 2 is a half-cut cell, the sum of numbers of the first busbar 21 and the second busbar 22 of the solar cell 2 is even, the number of the solar cells 2 in each of the first solar cell string 10, the second solar cell string 20, the third solar cell string 30, and the fourth solar cell string 40 is odd, the chamfer edges of a plurality of the solar cells 2 in the same solar cell string are arranged parallel, the chamfer edges of the solar cells 2 in the first solar cell string 10 are arranged opposite to the chamfer edges of the solar cells 2 in the third solar cell string 30, and the chamfer edges of the solar cells 2 in the second solar cell string 20 are arranged opposite to the chamfer edges of the solar cells 2 in the fourth solar cell string 40.

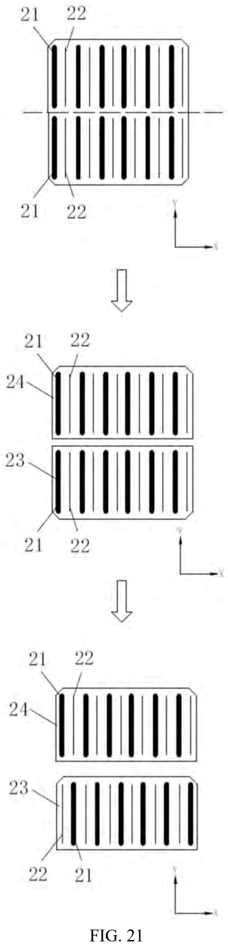

In some embodiments, as shown in FIG. 21, for step S1, the method for manufacturing the photovoltaic module includes:
Step A1: providing an original solar cell;
Step A2: cutting in a center line in the second direction of the original solar cell to obtain two cut cells; and
Step A3: rotating one of the cut cells by 180° to obtain the first solar cell 23 and the second solar cell 24 with chamfer edges arranged parallel.

In the above steps, the original solar cell has a center line (shown by the dashed line in FIG. 10) in the second direction X, and the original solar cell includes an upper part and a lower part that are symmetric with respect to the center line. The upper solar cell and the lower solar cell are respectively provided with a first busbar 21 and a second busbar 22 arranged alternately in the first direction X. The first busbar 21 of the upper solar cell and the first busbar 21 of the lower solar cell are aligned in the second direction Y, and the second busbar 22 of the upper solar cell and the second busbar 22 of the lower solar cell are aligned in the second direction Y. According to the above steps, one original solar cell is cut to obtain two available half-cut cells.

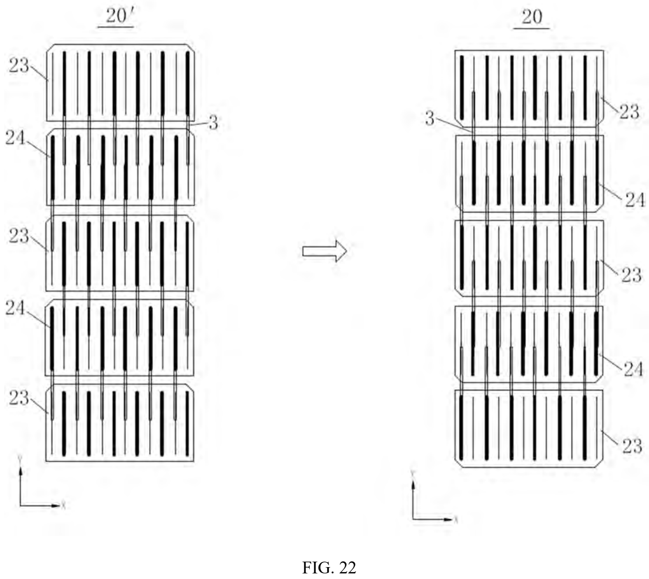

In some embodiments, as shown in FIG. 22, regarding step S2, for forming the second solar cell string 20, the method for manufacturing the photovoltaic module includes:
Step B1: alternately arranging a plurality of the first solar cells 23 and a plurality of the second solar cells 24 in the second direction Y, and connecting the first solar cell 23 and the second solar cell 24 that are adjacent through the solder strip 3 to obtain a pre-fabricated second solar cell string 20'.

In this step, the plurality of first solar cells 23 and the plurality of second solar cells 24 are arranged alternately in the second direction Y, and then the soldering strip 3 is laid and soldered by using a solar cell stringer, so that the first solar cells 23 and second solar cells 24 that are adjacent are connected in series in sequence.

Step B2: rotating the pre-fabricated second solar cell string 20' as a whole by 180° to obtain the second solar cell string 20.

In this step, the second solar cell string 20' is rotated counterclockwise or clockwise, enabling the obtained second solar cell string 20 to meet the layout requirements of the photovoltaic module.

In some embodiments, for forming the third solar cell string 30, the method for manufacturing the photovoltaic module includes: alternately arranging a plurality of the second solar cells 24 and a plurality of the first solar cells 23 in the second direction Y, and connecting the first solar cells 23 and the second solar cells 24 that are adjacent through the solder strip 3 to obtain the third solar cell string 30.

In this step, the plurality of the second solar cells 24 and the plurality of the first solar cells 23 are arranged alternately in the second direction Y, and then the soldering strip 3 is laid and soldered by using a solar cell stringer, so that the first solar cells 23 and the second solar cells 24 that are adjacent are connected in series in sequence. The soldering may also be completed manually, which is not limited in this embodiment.

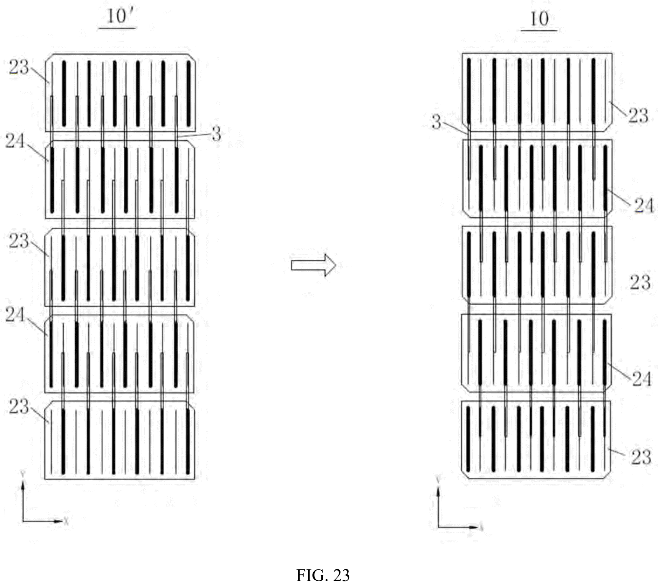

In some embodiments, as shown in FIG. 23, regarding step S2, for forming the first solar cell string 10, the method for manufacturing the photovoltaic module includes:
Step C1: alternately arranging a plurality of the first solar cells 23 and a plurality of the second solar cells 24 in the second direction Y.
Step C2: connecting the first solar cell 23 and the second solar cell 24 that are adjacent through the solder strip 3 to obtain a pre-fabricated first solar cell string 10', where the solder strip 3 in the pre-fabricated first solar cell string 10' and the solder strip 3 in the pre-fabricated second solar cell string 20' are arranged in a mirror-symmetric distribution.

In the above steps, the plurality of the first solar cells 23 and the plurality of the second solar cells 24 are arranged alternately in the second direction Y, and then the soldering strip 3 is laid by using a solar cell stringer and soldered by adopting the mirror function of the solar cell, to connect in series in sequence the first solar cells 23 and second solar cells 24 that are adjacent, thereby resulting in that the solder strip 3 in the pre-fabricated second solar cell string 20' are arranged in a mirror-symmetric distribution with respect to the first direction X. The soldering may also be completed manually, which is not limited in this embodiment.

Step C3: rotating the pre-fabricated first solar cell string 10' as a whole by 180° to obtain the first solar cell string 10.

In this step, the first solar cell string 10' is rotated counterclockwise or clockwise, enabling the obtained first solar cell string 10 to meet the layout requirements of the photovoltaic module.

In some embodiments, for forming the fourth solar cell string 40, the method for manufacturing the photovoltaic module includes:
Step D1: alternately arranging a plurality of the second solar cells 24 and a plurality of the first solar cells 23 in the second direction Y; and
Step D2: connecting the first solar cells 23 and the second solar cells 24 that are adjacent through the solder strip 3 to obtain the fourth solar cell string 40, where the solder strip 3 in the fourth solar cell string 40 and the solder strip 3 in the third solar cell string 30 are arranged in a mirror-symmetric distribution.

In the above steps, the plurality of the second solar cells 24 and the plurality of the first solar cells 23 are arranged alternately in the second direction Y, and then the soldering strip 3 is laid by using a solar cell stringer and soldered by adopting the mirror function of the solar cell, to connect in series in sequence the first solar cells 23 and second solar cells 24 that are adjacent, thereby resulting in that the soldering strips 3 in the fourth solar cell string 40 and the soldering strips 3 in the third solar cell string 30 are arranged in a mirror-symmetric distribution with respect to the first direction X. The soldering may also be completed manually, which is not limited in this embodiment.

In some embodiments, after step S3, the method for manufacturing the photovoltaic module further includes:
Step S4: connecting the second busbar 22 of the fifth end solar cell 205 and the first busbar 21 of the sixth end solar cell 206 respectively to the first edge current collector 4 through the solder strip 3, and connecting the second busbar 22 of the seventh end solar cell 207 and the first busbar 21 of the eighth end solar cell 208 respectively to the second edge current collector 5 through the solder strip 3.

In this step, by connecting the first solar cell string 10 and the second solar cell string 20 to the first edge current collector 4, and connecting the third solar cell string 30 and the fourth solar cell string 40 to the second edge current collector 5, a complete circuit structure of the photovoltaic module is formed. The numbers of the first solar cell string 10, the second solar cell string 20, the third solar cell string 30, and the fourth solar cell string 40 are not limited.

The above descriptions are only preferred embodiments of the present disclosure and are not intended to limit the present disclosure, and various modifications and changes may be made by those skilled in the art. The scope of the present disclosure shall be defined by the appended claims.

## Claims

1. A photovoltaic module, **characterized in that** the photovoltaic module comprises:
a first solar cell string group (101) comprising a first solar cell string (10) and a second solar cell string (20) arranged alternately in a first direction;
a second solar cell string group (102) comprising a third solar cell string (30) and a fourth solar cell string (40) arranged alternately in the first direction; and
a center current collector (1) located between the first solar cell string group (101) and the second solar cell string group (102), wherein a plurality of center current collectors (1) are spaced apart in the first direction,
wherein the first solar cell string (10), the second solar cell string (20), the third solar cell string (30), and the fourth solar cell string (40) respectively comprise a plurality of solar cells (2) spaced apart in a second direction, and the solar cell (2) is a back contact solar cell or a back contact tandem solar cell,
wherein the solar cell (2) comprises a first busbar (21) and a second busbar (22) spaced apart in the first direction, wherein ends, closed to the center current collector (1), of the first solar cell string (10), the second solar cell string (20), the third solar cell string (30), and the fourth solar cell string (40) respectively have a first end solar cell (201), a second end solar cell (202), a third end solar cell (203), and a fourth end solar cell (204), wherein an edge busbar, adjacent to the second end solar cell (202), of the first end solar cell (201) and an edge busbar, adjacent to the fourth end solar cell (204), of the third end solar cell (203) are both the second busbar (22), and wherein an edge busbar, adjacent to the first end solar cell (201), of the second end solar cell (202) and an edge busbar, adjacent to the third end solar cell (203), of the fourth end solar cell (204) are both the first busbar (21),
wherein the first busbar (21) of the first end solar cell (201) and the first busbar (21) of the third end solar cell (203) are respectively connected to the same center current collector (1) through a solder strip (3), and wherein the second busbar (22) of the second end solar cell (202) and the second busbar (22) of the fourth end solar cell (204) are respectively connected to another adjacent center current collector (1) through the solder strip (3),
wherein a chamfer edge of the first end solar cell (201) is arranged opposite to a chamfer edge of the third end solar cell (203), and wherein a chamfer edge of the second end solar cell (202) is arranged opposite to a chamfer edge of the fourth end solar cell (204), and
wherein the first direction is perpendicular to the second direction.

2. The photovoltaic module according to claim 1, **characterized in that** chamfer edges of any two adjacent solar cells (2) in the first direction are arranged parallel.

3. The photovoltaic module according to claim 1, **characterized in that** chamfer edges of a plurality of the solar cells (2) in the same cell string are arranged parallel.

4. The photovoltaic module according to claim 1, **characterized in that** a chamfer size of the solar cell (2) is A×45°, wherein A satisfies 1 mm ≤ A ≤ 2 mm.

5. The photovoltaic module according to claim 1, **characterized in that** in the first direction, a spacing L1 between two adjacent center current collectors (1) ranges from 15 mm to 25 mm.

6. The photovoltaic module according to claim 1, **characterized in that** the solder strip (3) comprises a first solder strip (31) and a second solder strip (32), wherein the first solder strip (31) serves to connect the center current collector (1) with the first busbar (21) of the first end solar cell (201), and the second solder strip (32) serves to connect the center current collector (1) with the first busbar (21) of the third end solar cell (203), and wherein the first solder strip (31) and the second solder strip (32) are staggered in the second direction; and/or
the solder strip (3) comprises a third solder strip (33) and a fourth solder strip (34), wherein the third solder strip (33) serves to connect the center current collector (1) with the second busbar (22) of the second end solar cell (202), and the fourth solder strip (34) serves to connect the center current collector (1) with the second busbar (22) of the fourth end solar cell (204), and wherein the third solder strip (33) and the fourth solder strip (34) are staggered in the second direction.

7. The photovoltaic module according to claim 1, **characterized in that** the photovoltaic module further comprises: a first edge current collector (4) and a second edge current collector (5) arranged opposite in the second direction,
wherein ends, closed to the first edge current collector (4), of the first solar cell string (10) and of the second solar cell string (20) respectively have a fifth end solar cell (205) and a sixth end solar cell (206), and wherein the second busbar (22) of the fifth end solar cell (205) and the first busbar (21) of the sixth end solar cell (206) are respectively connected to the first edge current collector (4) through the solder strip (3), and
wherein ends, closed to the second edge current collector (5), of the third solar cell string (30) and of the fourth solar cell string (40) respectively have a seventh end solar cell (207) and an eighth end solar cell (208), and wherein the second busbar (22) of the seventh end solar cell (207) and the first busbar (21) of the eighth end solar cell (208) are respectively connected to the second edge current collector (5) through the solder strip (3).

8. The photovoltaic module according to claim 7, **characterized in that** a number of the solar cells (2) in each of the first solar cell string (10), the second solar cell string (20), the third solar cell string (30), and the fourth solar cell string (40) is even;
wherein an edge busbar, adjacent to the sixth end solar cell (206), of the fifth end solar cell (205) and an edge busbar, adjacent to the eighth end solar cell (208), of the seventh end solar cell (207) are both the first busbars (21); and
wherein an edge busbar, adjacent to the fifth end solar cell (205), of the sixth end solar cell (206) and an edge busbar, adjacent to the seventh end solar cell (207), of the eighth end solar cell (208) are both the second busbars (22).

9. The photovoltaic module according to claim 7, **characterized in that** a number of the solar cells (2) in each of the first solar cell string (10), the second solar cell string (20), the third solar cell string (30), and the fourth solar cell string (40) is odd;
wherein an edge busbar, adjacent to the sixth end solar cell (206), of the fifth end solar cell (205) and an edge busbar, adjacent to the eighth end solar cell (208), of the seventh end solar cell (207) are both the second busbars (22); and
wherein an edge busbar, adjacent to the fifth end solar cell (205), of the sixth end solar cell (206) and an edge busbar, adjacent to the seventh end solar cell (207), of the eighth end solar cell (208) are both the first busbars (21).

10. The photovoltaic module according to claim 1, **characterized in that** a sum of numbers of the first busbar (21) and the second busbar (22) of the solar cell (2) is even.

11. The photovoltaic module according to claim 10, **characterized in that** the solar cell (2) is a cut cells, wherein the solar cell (2) comprises a first solar cell (23) and a second solar cell (24), and wherein one of the first solar cell (23) and the second solar cell (24) has a structure that is symmetrical to a 180° rotated structure of the other one.

12. A method for manufacturing a photovoltaic module, **characterized in that** the method comprises:
providing a solar cell (2), wherein the solar cell (2) is a back contact solar cell or a back contact tandem solar cell, wherein the solar cell (2) comprises a first busbar (21) and a second busbar (22) spaced apart in a first direction, and wherein the wherein cell (2) further has a chamfer edge;
arranging a plurality of the solar cells (2) in a second direction to respectively form a first solar cell string (10), a second solar cell string (20), a third solar cell string (30), and a fourth solar cell string (40), wherein the first solar cell string (10), the second solar cell string (20), the third solar cell string (30), and the fourth solar cell string (40) respectively have a first end solar cell (201), a second end solar cell (202), a third end solar cell (203), and a fourth end solar cell (204), wherein an edge busbar, adjacent to the second end solar cell (202), of the first end solar cell (201) and an edge busbar, adjacent to the fourth end solar cell (204), of the third end solar cell (203) are both the second busbars (22), wherein an edge busbar, adjacent to the first end solar cell (201), of the second end solar cell (202) and an edge busbar, adjacent to the third end solar cell (203), of the fourth end solar cell (204) are both the first busbars (21), wherein a chamfer edge of the first end solar cell (201) is arranged opposite to a chamfer edge of the third end solar cell (203), and wherein a chamfer edge of the second end solar cell (202) is arranged opposite to a chamfer edge of the fourth end solar cell (204); and
connecting the first busbar (21) of the first end solar cell (201) and the first busbar (21) of the third end solar cell (203) to the same center current collector (1), and connecting the second busbar (22) of the second end solar cell (202) and the second busbar (22) of the third end solar cell (203) to another adjacent center current collector (1),
wherein the second direction is perpendicular to the first direction.

13. The method for manufacturing a photovoltaic module according to claim 12, **characterized in that** chamfer edges of a plurality of the solar cells (2) in the same solar cell string are arranged parallel, wherein a sum of numbers of the first busbar (21) and the second busbar (22) of the solar cell (2) is even, wherein the solar cell (2) is a cut cell, and wherein the solar cell (2) comprises a first solar cell (23) and a second solar cell (24) that are rotationally symmetrical; and
wherein for providing the solar cell (2), the method for manufacturing the photovoltaic module comprises:
providing an original solar cell;
cutting in a center line in the second direction of the original solar cell to obtain two cut cells; and
rotating one of the cut cells by 180° to obtain the first solar cell (23) and the second solar cell (24) with chamfer edges arranged parallel.

14. The method for manufacturing a photovoltaic module according to claim 13, **characterized in that** a number of the solar cells (2) in each of the first solar cell string (10), the second solar cell string (20), the third solar cell string (30), and the fourth solar cell string (40) is odd; and
wherein for forming the second solar cell string (20), the method for manufacturing a photovoltaic module comprises:
alternately arranging a plurality of first solar cells (23) and a plurality of second solar cells (24) in the second direction, and connecting the first solar cell (23) and the second solar cell (24) that are adjacent through a solder strip (3) to obtain a pre-fabricated second solar cell string (20'); and
rotating the pre-fabricated second solar cell string (20') as a whole by 180° to obtain the second solar cell string (20); and/or
wherein for forming the third solar cell string (30), the method for manufacturing a photovoltaic module comprises:
alternately arranging a plurality of the second solar cells (24) and a plurality of the first solar cells (23) in the second direction, and connecting the first solar cell (23) and the second solar cell (24) that are adjacent through the solder strip (3) to obtain the third solar cell string (30).

15. The method for manufacturing a photovoltaic module according to claim 14, **characterized in that** for forming the first solar cell string (10), the method for manufacturing a photovoltaic module comprises:
alternately arranging a plurality of the first solar cells (23) and a plurality of the second solar cells (24) in the second direction;
connecting the first solar cell (23) and the second solar cell (24) that are adjacent through the solder strip (3) to obtain a pre-fabricated first solar cell string (10'), wherein the solder strip (3) in the pre-fabricated first solar cell string (10') and the solder strip (3) in the pre-fabricated second solar cell string (20') are arranged in a mirror-symmetric distribution; and
rotating the pre-fabricated first solar cell string (10') as a whole by 180° to obtain the first solar cell string (10); and/or
for forming the fourth solar cell string (40), the method for manufacturing a photovoltaic module comprises:
alternately arranging a plurality of the second solar cells (24) and a plurality of the first solar cells (23) in the second direction; and
connecting the first solar cell (23) and the second solar cell (24) that are adjacent through the solder strip (3) to obtain the fourth solar cell string (40), wherein the solder strip (3) in the fourth solar cell string (40) and the solder strip (3) in the third solar cell string (30) are arranged in a mirror-symmetric distribution.
